# EUROPEAN PATENT APPLICATION

(11) **EP 4 715 816 A1**
(43) Date of publication of application: **25.03.2026**
(21) Application number: 25157895.1
(22) Date of filing: 14.02.2025
(51) Int. Cl.: G11C 5/06, G11C 16/26, G11C 16/32, G11C 16/34, G11C 16/08, G11C 16/30, G11C 8/08

(54) **SEMICONDUCTOR MEMORY DEVICE**

(30) Priority: 20.09.2024 JP 2024163349
(71) Applicant: Kioxia Corporation, Tokyo 108-0023 (JP)
(72) Inventor: KATO, Koji, Minato-ku, Tokyo, 108-0023 (JP)
(74) Representative: Hoffmann Eitle

(57) **Abstract**

In general, according to one embodiment, a semiconductor memory device includes: first, second, and third interconnect layers sequentially arranged while being apart from one another in a first direction; a memory pillar extending in the first direction and including a portion intersecting the first interconnect layer and functioning as a first memory cell; and a control circuit controlling a read operation of the first memory cell, wherein, during the read operation, the control circuit performs a first operation of rising a voltage of the third interconnect layer from a first to a second voltage at a first rate; a second operation of rising a voltage of the second interconnect layer from the first to a third voltage at a second rate higher than the first rate; and, a third operation of changing a voltage of the first interconnect layer to a read level voltage.

## Description

### CROSS-REFERENCE TO RELATED APPLICATIONS

This application is based upon and claims the benefit of priority from Japanese Patent Application No. 2024-163349, filed September 20, 2024.

### FIELD

Embodiments described herein relate generally to a semiconductor memory device.

### BACKGROUND

NAND flash memories are known as semiconductor memory devices capable of memorizing data in a nonvolatile manner. In a case where data memorized in a selected memory cell transistor is read in a NAND flash memory, a higher voltage than the read voltage is applied to the other memory cell transistors present on the same NAND string as the selected memory cell transistor.

### BRIEF DESCRIPTION OF THE DRAWINGS

FIG. 1 is a block diagram showing an example configuration of a memory system according to a first embodiment.
FIG. 2 is a circuit diagram showing an example circuit configuration of the memory cell array included in a semiconductor memory device according to the first embodiment.
FIG. 3 is a plan view showing an example of the planar layout of the memory cell array included in the semiconductor memory device according to the first embodiment.
FIG. 4 is a plan view showing an example of the planar layout in a memory area in the memory cell array included in the semiconductor memory device according to the first embodiment.
FIG. 5 is a cross-sectional view taken along the line V-V defined in FIG. 4 and showing an example of a cross-sectional structure in the memory area in the memory cell array included in the semiconductor memory device according to the first embodiment.
FIG. 6 is a cross-sectional view taken along the line VI-VI in FIG. 5 and showing an example cross-sectional structure of a memory pillar included in the semiconductor memory device according to the first embodiment.
FIG. 7 is a circuit diagram showing an example circuit configuration of a row decoder module included in the semiconductor memory device according to the first embodiment.
FIG. 8 is a circuit diagram showing an example circuit configuration of a driver module included in a semiconductor memory device according to the first embodiment.
FIG. 9 is a diagram showing an example of threshold distributions, read voltages, and verify voltages of memory cell transistors in the semiconductor memory device according to the first embodiment.
FIG. 10 is a timing chart showing an example read operation of reading lower page data in the semiconductor memory device according to the first embodiment.
FIG. 11 is a diagram showing an example of the order of data write in a NAND string included in the semiconductor memory device according to the first embodiment.
FIG. 12 is a timing chart showing an example write operation in the semiconductor memory device according to the first embodiment.
FIG. 13 is a timing chart showing an example read operation of reading lower page data in a semiconductor memory device according to a second embodiment.
FIG. 14 is a circuit diagram showing an example circuit configuration of a driver module included in a semiconductor memory device according to a third embodiment.
FIG. 15 is a timing chart showing an example read operation of reading lower page data in the semiconductor memory device according to the third embodiment.
FIG. 16 is a timing chart showing an example read operation of reading lower page data in a semiconductor memory device according to a fourth embodiment.
FIG. 17 is a circuit diagram showing an example circuit configuration of a driver module included in a semiconductor memory device according to a fifth embodiment.
FIG. 18 is a timing chart showing an example read operation of reading lower page data in the semiconductor memory device according to the fifth embodiment.
FIG. 19 is a circuit diagram showing an example circuit configuration of a driver module included in a semiconductor memory device according to a sixth embodiment.
FIG. 20 is a timing chart showing an example write operation in the semiconductor memory device according to the sixth embodiment.
FIG. 21 is a timing chart showing an example write operation in a semiconductor memory device according to a seventh embodiment.
FIG. 22 is a timing chart showing an example write operation in a semiconductor memory device according to an eighth embodiment.
FIG. 23 is a timing chart showing an example write operation in a semiconductor memory device according to a ninth embodiment.
FIG. 24 is a circuit diagram showing an example circuit configuration of a driver module included in a semiconductor memory device according to a tenth embodiment.
FIG. 25 is a timing chart showing an example write operation in the semiconductor memory device according to the tenth embodiment.

### DETAILED DESCRIPTION

In general, according to one embodiment, a semiconductor memory device includes: a first interconnect layer, a second interconnect layer, and a plurality of third interconnect layers that are sequentially arranged while being apart from one another in a first direction; a memory pillar that extends in the first direction and includes a portion intersecting the first interconnect layer and functioning as a first memory cell; and a control circuit that controls a read operation of reading data memorized in the first memory cell, wherein, during the read operation, the control circuit performs a first operation of changing a voltage of the plurality of third interconnect layers from a first voltage to a second voltage higher than the first voltage at a first rate; a second operation of changing a voltage of the second interconnect layer from the first voltage to a third voltage higher than the second voltage at a second rate higher than the first rate; and, a third operation of changing a voltage of the first interconnect layer to a fourth voltage which is a read level voltage of the first memory cell.

In the description below, embodiments will be described with reference to the drawings. The drawings are schematic, and dimensions and ratios in the drawings are not necessarily the same as actual ones. In the description below, components having substantially the same functions and configurations are denoted by the same reference numerals. In a case where elements having similar configurations are particularly distinguished from each other, different characters or numbers may be added to the ends of the same reference numerals.

In the description below, a first element "being coupled to" a second element includes the first element being coupled to the second element either indirectly via an intermediate element that is always or selectively conductive, or directly without any intermediate element.

### 1. First Embodiment

### 1.1 Configuration

### 1.1.1 Memory System

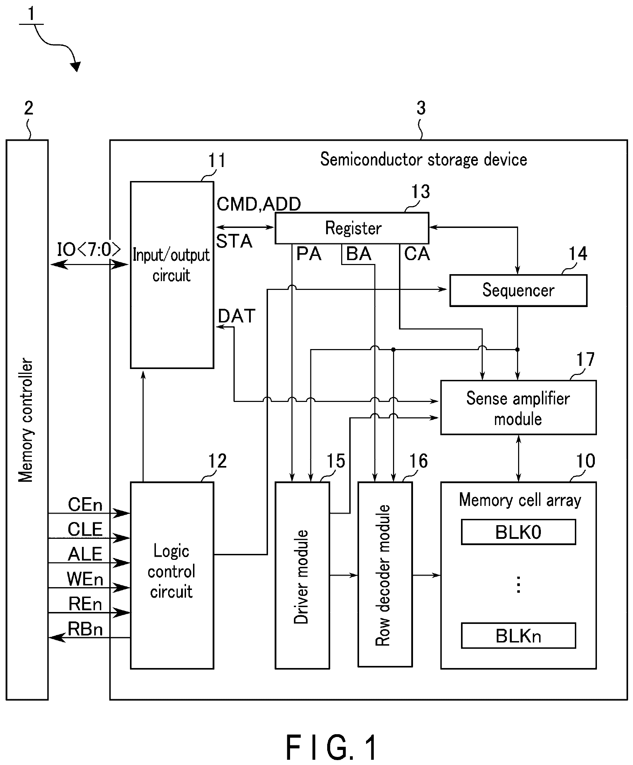

A semiconductor memory device according to a first embodiment is described. FIG. 1 is a block diagram showing an example configuration of a memory system according to the first embodiment. A memory system 1 is a memory device designed to be coupled to an external host device (not shown). The memory system 1 is a memory card such as an SD card (registered trademark), a universal flash storage (UFS), or a solid-state drive (SSD), for example. The memory system 1 includes a memory controller 2 and a semiconductor memory device 3.

The memory controller 2 is formed with an integrated circuit such as a system on a chip (SoC), for example. The memory controller 2 controls the semiconductor memory device 3, based on a request from the external host device. Specifically, the memory controller 2 writes the data requested to be written by the external host device into the semiconductor memory device 3. Also, the memory controller 2 reads the data requested to be read by the external host device from the semiconductor memory device 3, and outputs the data to the external host device.

The semiconductor memory device 3 is a memory that memorizes data in a volatile or nonvolatile manner, for example. In the description below, a case where the semiconductor memory device 3 is a NAND flash memory is described.

Communication between the memory controller 2 and the semiconductor memory device 3 conforms to a single data rate (SDR) interface, a toggle double data rate (DDR) interface, or an open NAND flash interface (ONFI), for example. Signals including signals IO<7:0>, CEn, CLE, ALE, WEn, REn, and RBn, for example, are exchanged between the memory controller 2 and the semiconductor memory device 3.

### 1.1.2 Semiconductor Memory Device

Next, the internal configuration of the semiconductor memory device 3 according to the first embodiment is described with reference to the block diagram shown in FIG. 1. The semiconductor memory device 3 includes a memory cell array 10, an input/output circuit 11, a logic control circuit 12, a register 13, a sequencer 14, a driver module 15, a row decoder module 16, and a sense amplifier module 17, for example.

The memory cell array 10 is a set of memory cell transistors and a set of components coupled to the memory cell transistors. The memory cell array 10 includes a plurality of blocks BLK0 to BLKn (n being an integer of 1 or greater). A block BLK is a set of a plurality of memory cell transistors capable of memorizing data in a nonvolatile manner. The blocks BLK are used as erase units when data memorized in the memory cell transistors is erased, for example. Also, a plurality of bit lines and a plurality of word lines are provided in the memory cell array 10. Each memory cell transistor is associated with a combination of one bit line and one word line, for example. The configuration of the memory cell array 10 will be described later in detail.

The input/output circuit 11 is an interface circuit responsible for the transmission and reception of the signal IO<7:0> with the memory controller 2. The signal IO<7:0> is an 8-bit signal. The signal IO<7:0> includes data DAT, a command CMD, address information ADD, and status information STA, for example. The input/output circuit 11 inputs and outputs the data DAT between the sense amplifier module 17 and the memory controller 2. The input/output circuit 11 outputs the command CMD and the address information ADD transferred from the memory controller 2, to the register 13. The input/output circuit 11 outputs the status information STA transferred from the register 13, to the memory controller 2.

The logic control circuit 12 is an interface circuit responsible for the reception of the signals CEn, CLE, ALE, WEn, and REn input from the memory controller 2, and transmission of the signal RBn to the memory controller 2. The logic control circuit 12 controls each of the input/output circuit 11 and the sequencer 14, based on the signals CEn, CLE, ALE, WEn, and REn. For example, the logic control circuit 12 controls the sequencer 14 based on the signal CEn, to enable the semiconductor memory device 3. The logic control circuit 12 notifies the input/output circuit 11 that the signal IO<7:0> received by the input/output circuit 11 is whether the command CMD or the address information ADD, based on the signals CLE and ALE, respectively. The logic control circuit 12 commands the input/output circuit 11 to input and output the signal IO<7:0>, based on the signals WEn and REn. Also, the logic control circuit 12 outputs the signal REn indicating whether the semiconductor memory device 3 is in a ready state (a state of receiving a command from the outside) or a busy state (a state of not receiving a command from the outside), to the memory controller 2.

The register 13 temporarily memorizes the command CMD, the address information ADD, and the status information STA. The command CMD includes a command for causing the sequencer 14 to execute a read operation, a write operation, an erase operation, or the like, for example. The address information ADD includes a block address BA, a page address PA, and a column address CA, and the like. For example, the block address BA, the page address PA, and the column address CA are used to select a block BLK, a word line, and a bit line, respectively. The status information STA is used to notify the memory controller 2 whether the operation has been properly ended. The status information STA is updated under the control of the sequencer 14, and is transferred to the input/output circuit 11.

The sequencer 14 controls the entire operation of the semiconductor memory device 3. For example, the sequencer 14 controls the driver module 15, the row decoder module 16, the sense amplifier module 17, and the like, based on the command CMD memorized in the register 13. The sequencer 14 executes a read operation, a write operation, or an erase operation, for example.

The driver module 15 generates voltages of a plurality of different magnitudes, to be used in a read operation, a write operation, an erase operation, and the like. The driver module 15 supplies the generated voltages to the row decoder module 16, the sense amplifier module 17, and the like. Also, the driver module 15 applies the generated voltage to the signal line corresponding to the word line selected based on the page address PA memorized in the register 13, for example.

The row decoder module 16 selects the one corresponding block BLK in the memory cell array 10, based on the block address BA memorized in the register 13, for example. The row decoder module 16 transfers the voltage of the signal line applied by the driver module 15, for example, to the selected word line in the selected block BLK.

The sense amplifier module 17 includes a sense amplifier unit capable of determining data based on the voltage of the associated bit line, a latch circuit that temporarily memorizes the data, and the like. In the write operation, the sense amplifier module 17 applies a predetermined voltage to each bit line, in accordance with write data DAT received from the input/output circuit 11. Also, the sense amplifier module 17 determines the data memorized in the memory cell transistor in a read operation, based on the magnitude of the voltage of the bit line. After that, the sense amplifier module 17 transfers the determination result as read data DAT to the input/output circuit 11.

### 1.1.3 Circuit Configuration of the Memory Cell Array

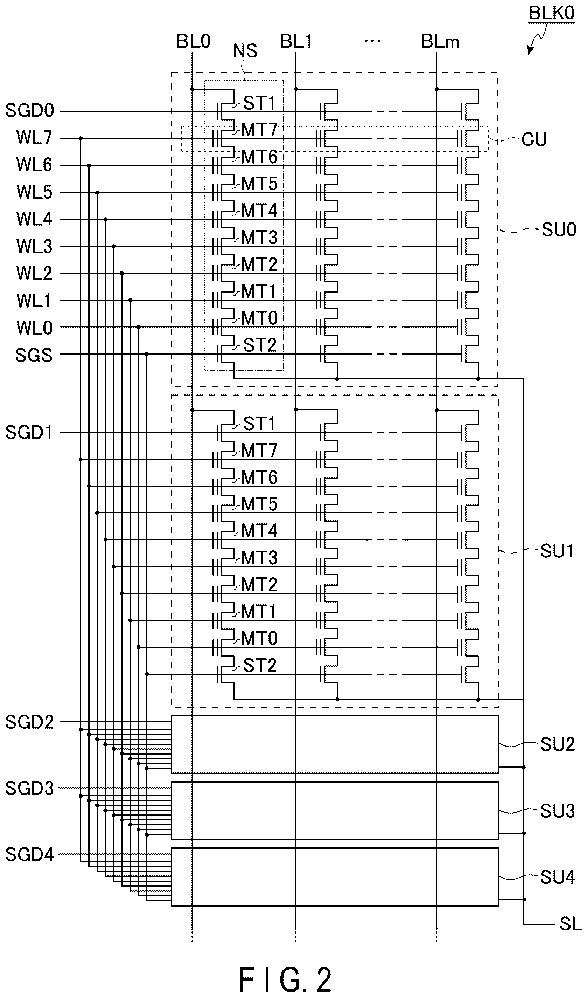

FIG. 2 is a circuit diagram showing an example circuit configuration of the memory cell array included in the semiconductor memory device according to the first embodiment. FIG. 2 shows the block BLK0. The block BLK0 includes five string units SU0 to SU4, for example.

Each string unit SU includes a plurality of NAND strings NS associated with the respective bit lines BL0 to BLm (m being an integer of 1 or greater). Each NAND string NS includes eight memory cell transistors MT0 to MT7, and select transistors ST1 and ST2, for example. Each memory cell transistor MT includes a control gate and a charge storage film, and memorizes data in a nonvolatile manner based on the amount of electric charge in the charge storage film. Each of the select transistors ST1 and ST2 is used to select a string unit SU during various operations.

In each NAND string NS, the memory cell transistors MT0 to MT7 are coupled in series in this order. The drain of the select transistor ST1 is coupled to the associated bit line BL, and the source of the select transistor ST1 is coupled to the drain of the memory cell transistor MT7. The drain of the select transistor ST2 is coupled to the source of the memory cell transistor MT0, and the source of the select transistor ST2 is coupled to a source line SL.

The control gates (hereinafter referred to simply as the gates) of the memory cell transistors MT0 to MT7 in the same block BLK are coupled to the word lines WL0 to WL7, respectively. The gates of the select transistors ST1 in the string units SU0 to SU4 are coupled to select gate lines SGD0 to SGD4, respectively. The gates of the select transistors ST2 in the same block BLK are coupled to a select gate line SGS.

Different column addresses CA are allocated to the respective bit lines BLO to BLm. Each bit line BL is shared by the NAND strings NS to which the same column address CA is allocated among the plurality of blocks BLK. Each of the word lines WL0 to WL7 is provided for each block BLK. The source line SL is shared among the plurality of blocks BLK, for example.

A set of a plurality of memory cell transistors MT coupled to a common word line WL in one string unit SU is referred to as a cell unit CU. For example, the storage capacity of a cell unit CU including memory cell transistors MT each memorizing 1-bit data is defined as "1-page data". A cell unit CU may have a storage capacity of 2-page data or larger, depending on the number of bits in the data memorized in the memory cell transistor MT. In the description below, a case where a memory cell transistor MT is a triple level cell (TLC) that memorizes 3-bit data will be described. That is, each cell unit CU has a storage capacity of 3-page data.

Note that the circuit configuration of the memory cell array 10 included in the semiconductor memory device 3 according to the first embodiment is not limited to the above description. For example, the number of string units SU included in each block BLK can be designed to be any appropriate number. The number of memory cell transistors MT and the number of select transistors ST1 and ST2 included in each NAND string NS can be designed to be any appropriate number.

### 1.1.4 Structure of the Memory Cell Array

In the description below, an example structure of the memory cell array 10 included in the semiconductor memory device 3 according to the first embodiment is described. In the following description, the extending direction of the word lines WL is defined as the X direction. The extending direction of the bit lines BL is defined as the Y direction. When viewed from the side of the source line SL, the direction in which interconnects corresponding to the select gate lines SGD and SGS and the word lines WL are stacked is defined as the Z direction or the upward direction. The direction opposite to the upward direction is defined as the downward direction. In a plan view, hatching is appropriately added, to enhance the visibility of the drawing. The hatching added in a plan view is not necessarily associated with the material or the characteristics of the component to which the hatching is added.

### 1.1.4.1 Overview

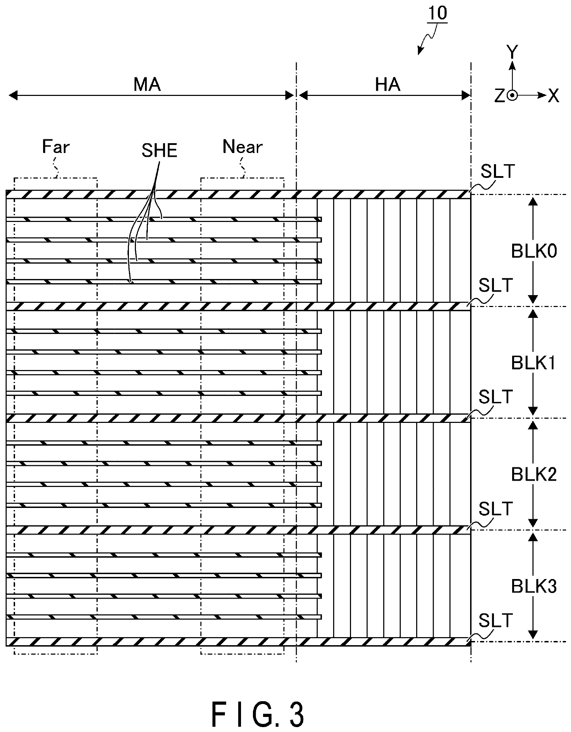

FIG. 3 is a plan view showing an example of the planar layout of the memory cell array included in the semiconductor memory device according to the first embodiment. In FIG. 3, the region corresponding to the four blocks BLK0 to BLK3 is illustrated. The sequential numbers at the ends for distinguishing the blocks BLK are assigned in ascending order from the top side of the drawing. In the memory cell array 10, the layout illustrated in FIG. 3 repeatedly appears in the Y direction, for example. As illustrated in FIG. 3, the memory cell array 10 includes stacked interconnects formed with a plurality of interconnect layers (the word lines WL0 to WL7, and the select gate lines SGS and SGD, for example) that are stacked apart from each other in the Z direction, a plurality of members SLT, and a plurality of members SHE. The planar layout of the memory cell array 10 is divided into a memory area MA and a hookup area HA in the X direction, for example.

The memory area MA is a region that includes a plurality of NAND strings NS and is used to memorize data. The hookup area HA is a region that is used for coupling between each of the stacked interconnects and the row decoder module 16. For example, each of the stacked interconnects is formed in a step-like shape so as to be coupled to the row decoder module 16 from the side of the bit lines BL, without interfering with the other interconnect layers in the hookup area HA.

Each of the members SLT extends in the X direction, and the members SLT are arranged in the Y direction. Each member SLT crosses the memory area MA and the hookup area HA in the X direction in the boundary region between the adjacent blocks BLK. In other words, each of the regions divided by the members SLT corresponds to one block BLK in the memory cell array 10. Each member SLT has a structure in which an insulator and a plate-like contact are buried, for example. Each member SLT divides stacked interconnects adjacent to each other, with the member SLT interposed in between.

The plurality of members SHE is disposed in the memory area MA. Each of the members SHE is provided to cross the memory area MA in the X direction, and the members SHE are arranged in the Y direction. The end of each member SHE on the right side of the drawing is included in the hookup area HA. For example, in the memory area MA, four members SHE are disposed between members SLT adjacent to each other in the Y direction. Each of the regions divided by the members SLT and SHE in the memory area MA corresponds to one string unit SU in the memory cell array 10. Each member SHE has a structure in which an insulator is buried, for example. Each member SHE divides the select gate lines SGD adjacent to each other, with the member SHE interposed in between.

Note that the planar layout of the memory cell array 10 included in the semiconductor memory device 3 according to the first embodiment is not limited to the layout described above. For example, the number of members SHE disposed between adjacent members SLT can be designed to be any appropriate number. The number of string units SU formed between adjacent members SLT can be changed based on the number of members SHE disposed between the adjacent members SLT.

In the semiconductor memory device 3 according to the first embodiment, the word lines WL0 to WL7 extend in the X direction, and a voltage is applied from the row decoder module 16 via a contact (not shown) coupled in the hookup area HA. At this point of time, in a portion of the word lines WL far from the hookup area HA in the memory area MA, the influence of a delay cannot be ignored in some cases.

In the present specification, a "delay" indicates the length of an RC delay time that is the time from when a voltage is applied to a wiring line till the voltage of the wiring rises or falls to a target value. Also, in the description below, a portion far from the hookup area HA in the portion of the word line WLk (k being an integer satisfying 0 ≤ k ≤ 7) included in the memory area MA will be referred to as "the far end of the word line WLk", and is shown as "Far" in the drawings. A portion close to the hookup area HA in the portion of the word line WLk included in the memory area MA will be referred to as "the near end of the word line WLk", and is shown as "Near" in the drawings. The timing at which the voltage reaches the target value may be different between the near end and the far end of the word line WLk.

Hereinafter, when a voltage is applied to a word line WL, the rate of rise or fall of the voltage at the near end of the word line WL at the start of the application will be referred to as a "slope".

### 1.1.4.2 Structure of the Memory Area

### (Planar Layout)

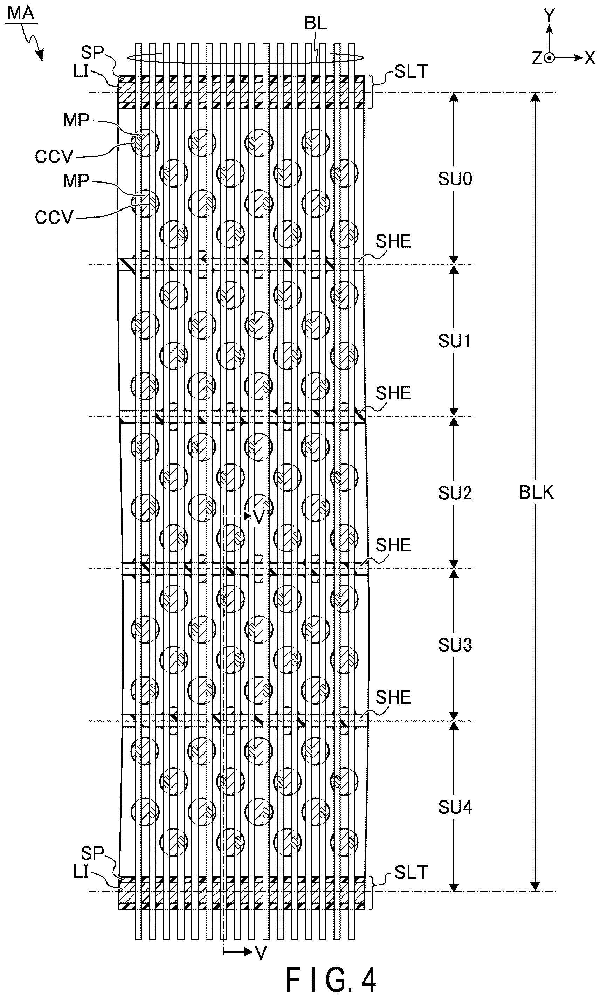

FIG. 4 is a plan view showing an example of the planar layout in the memory area in the memory cell array included in the semiconductor memory device according to the first embodiment. As illustrated in FIG. 4, in the memory area MA, the memory cell array 10 includes a plurality of memory pillars MP, a plurality of contacts CCV, and a plurality of bit lines BL. Also, each member SLT includes a contact LI and a spacer SP.

Each of the memory pillars MP functions as one NAND string NS, for example. The plurality of memory pillars MP is arranged in a staggered manner in twenty-four rows in the Y direction, for example, in the region between two adjacent members SLT. In the example illustrated in FIG. 4, one member SHE overlaps each of the memory pillars MP of the fifth row, the tenth row, the fifteenth row, and the twentieth row from the top side of the drawing.

Each of the bit lines BL extends in the Y direction, and the bit lines BL are arranged in the X direction. Each bit line BL is disposed so as to overlap at least one memory pillar MP in each string unit SU. In the example illustrated in FIG. 4, two bit lines BL are disposed so as to overlap one memory pillar MP. In a case where a plurality of bit lines BL overlaps a memory pillar MP, one bit line BL of the plurality of bit lines BL and the corresponding one memory pillar MP are electrically coupled via a contact CCV. Note that, in a case where only one bit line BL overlaps a memory pillar MP, the bit line BL and the corresponding one memory pillar MP are electrically coupled via a contact CCV.

For example, the contact CCV between a memory pillar MP in contact with a member SHE and the corresponding bit line BL is omitted. In other words, the contact CCV between a memory pillar MP and a bit line BL that are in contact with two different select gate lines SGD is omitted. The number and arrangement of the memory pillars MP, the members SHE, and the like between adjacent members SLT are not limited to the configuration illustrated in FIG. 4, and may be changed as appropriate. For example, the number of bit lines BL overlapping each memory pillar MP can be designed to be any appropriate number.

A contact LI is a conductor extending in the X-Z plane. The lower surface of a contact LI is in contact with the source line SL (not shown). A spacer SP is an insulator provided on side surfaces of a contact LI. In other words, a spacer SP is provided in contact with a contact LI so as to sandwich the contact LI in the Y direction.

### (Cross-Sectional Structure)

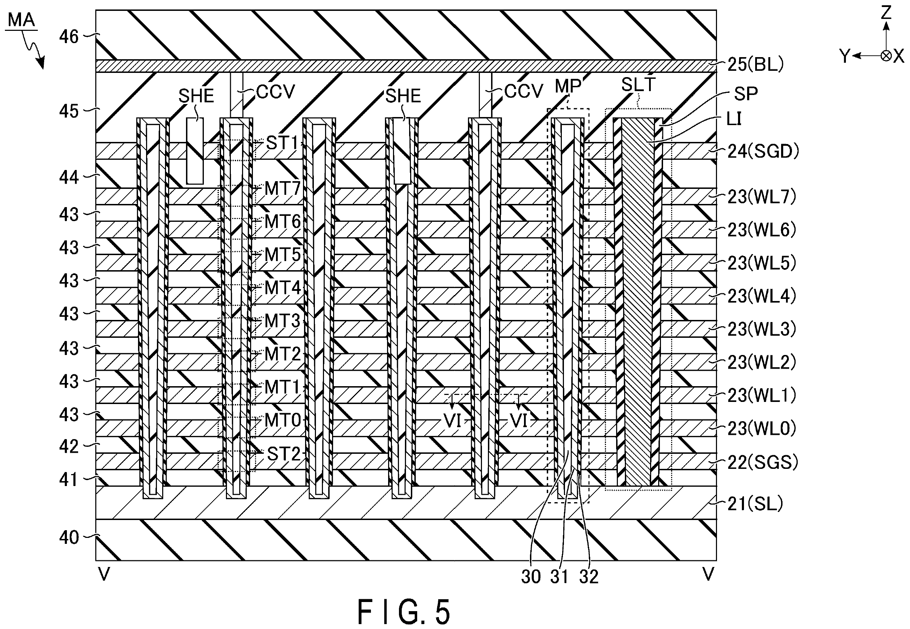

FIG. 5 is a cross-sectional view taken along the line V-V defined in FIG. 4 and showing an example of a cross-sectional structure in the memory area in the memory cell array included in the semiconductor memory device according to the first embodiment. As illustrated in FIG. 5, the memory cell array 10 further includes interconnect layers 21 to 25 and insulator layers 40 to 46.

As illustrated in FIG. 5, the insulator layer 40, the interconnect layer 21, the insulator layer 41, the interconnect layer 22, and the insulator layer 42 are stacked in this order. The interconnect layer 21 is formed in a plate-like shape extending in the X direction in the X-Y plane, for example. The interconnect layer 21 is used as the source line SL. The interconnect layer 21 contains phosphorus-doped silicon, for example. The interconnect layer 22 is formed in a plate-like shape extending in the X direction in the X-Y plane, for example. The interconnect layer 22 is used as the select gate line SGS. The interconnect layer 22 contains tungsten, for example. The insulator layer 40 includes interconnects and pads (not shown) for coupling the semiconductor memory device 3 to an external device, for example.

The interconnect layers 23 and the insulator layers 43 are alternately stacked over the insulator layer 42. In the example illustrated in FIG. 5, eight interconnect layers 23 and seven insulator layers 43 are alternately stacked. Each interconnect layer 23 is formed in a plate-like shape extending in the X direction in the X-Y plane, for example. The interconnect layers 23 are used as the word lines WL0 to WL7, respectively, in this order from the side of the interconnect layer 22. Each interconnect layer 23 contains tungsten, for example.

Over the uppermost interconnect layer 23, the insulator layer 44, the interconnect layer 24, and the insulator layer 45 are stacked in this order. The interconnect layer 24 is formed in a plate-like shape extending in the X direction in the X-Y plane, for example. The interconnect layer 24 is used as the select gate line SGD. The interconnect layer 24 contains tungsten, for example.

The interconnect layer 25 is stacked over the insulator layer 45. The interconnect layer 25 is formed in the form of a line extending in the Y direction, for example. The interconnect layer 25 is used as the bit line BL. In a region not shown in the drawing, a plurality of interconnect layers 25 is arranged in the X direction. The interconnect layer 25 contains copper, for example.

The insulator layer 46 is stacked over the interconnect layer 25. The insulator layer 46 includes a plurality of interconnects (not shown) for coupling to the row decoder module 16, the sense amplifier module 17, and the like, which are provided further above the memory cell array 10, for example.

Each of the memory pillars MP is provided to extend in the Z direction. Each of the memory pillars MP penetrates the interconnect layers 22 to 24 and the insulator layers 41 to 44.

Each of the memory pillars MP includes a core film 30, a semiconductor film 31, and a laminated film 32, for example. The core film 30 is provided to extend in the Z direction. For example, the upper end of the core film 30 is located in the insulator layer 45, and the lower end of the core film 30 is located in the interconnect layer 21. The core film 30 includes an insulator such as silicon oxide (SiO), for example. The semiconductor film 31 covers the circumference of the core film 30, for example. At the lower end of the memory pillar MP, part of the semiconductor film 31 is in contact with the interconnect layer 21. The semiconductor film 31 contains silicon, for example. The laminated film 32 covers the side surfaces of the semiconductor film 31, except for the portion at which the semiconductor film 31 and the interconnect layer 21 are in contact with each other.

In the structure of the memory pillar MP illustrated in FIG. 5, the portion at which the memory pillar MP intersects the interconnect layer 22 functions as the select transistor ST2. The portions at which the memory pillar MP intersects with the respective interconnect layers 23 function as the memory cell transistors MT0 to MT7. The portion at which the memory pillar MP intersects with the interconnect layer 24 functions as the select transistor ST1.

A columnar contact CCV is provided on the upper surface of the semiconductor film 31 in a memory pillar MP. In the region illustrated in FIG. 5, two contacts CCV each corresponding to one of two memory pillars MP among the six memory pillars MP are shown. The other four memory pillars which is not coupled to contacts CCV in FIG. 5 are each coupled to another contact in a region not shown in the drawing.

One interconnect layer 25, which is one bit line BL, is in contact with the upper surface of each contact CCV. One contact CCV is coupled to one interconnect layer 25 in each of the spaces partitioned with the members SLT and SHE. That is, one memory pillar MP in each region between adjacent members SLT and SHE, and one memory pillar MP in each region between two adjacent members SHE is electrically coupled to each of the interconnect layers 25, for example.

The members SLT are formed to spread in the X-Z plane, for example. Each of the members SLT divides the interconnect layers 22 to 24 and the insulator layers 41 to 44 in the Y direction.

In a member SLT, the contact LI is provided so as to spread in the X-Z plane, and the spacer SP is provided between the contact LI, and the interconnect layers 22 to 24 and the insulator layers 41 to 45. The upper end of the contact LI is located in the insulator layer 45, for example. The lower end of the contact LI is located in the interconnect layer 21, for example. Note that the contact LI may be omitted depending on the structure of the memory cell array 10.

A member SHE is formed in a plate-like shape spreading in the X-Z plane, for example, and divides the interconnect layer 24. The upper end of a member SHE is located in the insulator layer 45. The lower end of a member SHE is located in the insulator layer 44, for example. A member SHE includes an insulator such as silicon oxide (SiO), for example. Note that the upper ends of the members SHE and the upper ends of the members SLT may be aligned, or may not be aligned. Also, the upper ends of the members SHE and the upper ends of the memory pillars MP may be aligned, or may not be aligned.

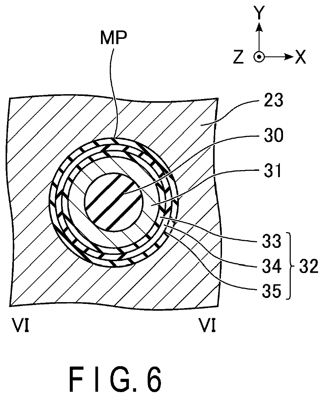

FIG. 6 is a cross-sectional view taken along the line VI-VI defined in FIG. 5 and showing an example cross-sectional structure of a memory pillar included in the semiconductor memory device according to the first embodiment. More specifically, FIG. 6 shows the cross-sectional structure of a memory pillar MP in an X-Y plane including the interconnect layer 23. As illustrated in FIG. 6, the laminated film 32 includes a tunnel insulating film 33, a charge storage film 34, and a block insulating film 35, for example.

In the cross-section including the interconnect layer 23, the core film 30 is located at the central portion of the memory pillar MP, for example. The semiconductor film 31 surrounds the side surface of the core film 30. The tunnel insulating film 33 surrounds the side surface of the semiconductor film 31. The charge storage film 34 surrounds the side surface of the tunnel insulating film 33. The block insulating film 35 surrounds the side surface of the charge storage film 34. The interconnect layer 23 surrounds the side surface of the block insulating film 35.

The semiconductor film 31 is used as a channel (current path) of the memory cell transistors MT0 to MT7 and the select transistors ST1 and ST2. The tunnel insulating film 33 is used as a potential barrier between the semiconductor film 31 and the charge storage film 34, and contains silicon oxide, for example. The charge storage film 34 has a function of accumulating charges, and contains silicon nitride (SiN), for example. The block insulating film 35 suppresses back tunneling of charges from the interconnect layer 23 to the memory pillar MP, and contains silicon oxide, for example. With this configuration, each memory pillar MP can function as one NAND string NS.

### 1.1.5 Circuit Configuration of the Row Decoder Module

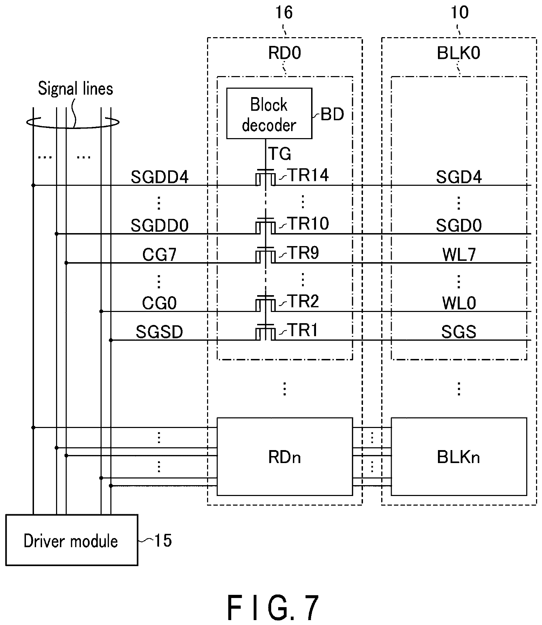

FIG. 7 is a circuit diagram showing an example circuit configuration of the row decoder module included in the semiconductor memory device according to the first embodiment. As illustrated in FIG. 7, the row decoder module 16 includes row decoders RD0 to RDn, for example.

A row decoder RD is used to select a block BLK. The row decoders RD0 to RDn are associated with the blocks BLK0 to BLKn, respectively.

In the description below, a detailed circuit configuration of a row decoder RD will be explained, with focusing on the row decoder RD0 corresponding to the block BLK0. The row decoders RD1 to RDn have the same configuration as the row decoder RD0.

A row decoder RD includes a block decoder BD and transistors TR1 to TR14, for example.

The block decoder BD decodes the block address BA. The block decoder BD applies a predetermined voltage to a transfer gate line TG, based on the decoding result. The transfer gate line TG is coupled to the gates of the transistors TR1 to TR14 in a shared manner.

The transistors TR1 to TR14 include N-channel metal-oxide-semiconductor field-effect transistors (MOSFETs) having a high withstand voltage and durability against a voltage VPRG described later, for example. The transistors TR1 to TR14 are coupled between various signal lines coupled from the driver module 15 and various wiring lines of the associated block BLK. In the description below, in a case where any limitation is not put on the source and the drain of a transistor, one of the source or the drain of the transistor will be referred to as "the first end", and one of the source or the drain of the transistor will be referred to as "the second end". A state in which the first end and the second end of a transistor are electrically coupled via the transistor will be referred to as an "ON-state", and a state in which the first end and the second end are electrically insulated from each other via the transistor will be referred to as an "OFF-state".

Specifically, signal lines SGDDO to SGDD4, signal lines CG0 to CG7, and a signal line SGSD are coupled to the driver module 15. The signal lines SGDDO to SGDD4 correspond to the select gate lines SGD0 to SGD4, respectively. The signal lines CG0 to CG7 correspond to the word lines WL0 to WL7, respectively. The signal line SGSD corresponds to the select gate line SGS.

The first end of the transistor TR1 is coupled to the signal line SGSD. The second end of the transistor TR1 is coupled to the select gate line SGS. The first ends of the transistors TR2 to TR9 are coupled to the signal lines CG0 to CG7, respectively. The second ends of the transistors TR2 to TR9 are coupled to the word lines WL0 to WL7, respectively. The first ends of the transistors TR10 to TR14 are coupled to the signal lines SGDDO to SGDD4. The second ends of the transistors TR10 to TR14 are coupled to the select gate lines SGD0 to SGD4, respectively.

With the above configuration, the row decoder module 16 can select the block BLK that executes various operations.

Specifically, during various operations, the block decoder BD corresponding to the selected block BLK applies a voltage at the high level to the transfer gate line TG, and each block decoder BD corresponding to the unselected blocks BLK applies a voltage at the low level to the transfer gate line. For example, in a case where the block BLK0 is selected, the transistors TR1 to TR14 included in the row decoder RD0 enter an ON-state, and the transistors TR1 to TR14 included in the row decoders RD1 to RDn enters an OFF-state. In this case, current paths between the various wiring lines provided in the block BLK0 and the corresponding signal lines are formed, and current paths between the various wiring lines provided in the blocks BLK1 to BLKn and the corresponding signal lines are cut off. As a result, the voltage applied to each signal line by the driver module 15 is applied to the various wiring lines provided in the selected block BLK0 via the row decoder RD0. The row decoder module 16 can operate in the same manner in a case where some other block BLK is selected.

### 1.1.6 Circuit Configuration of the Driver Module

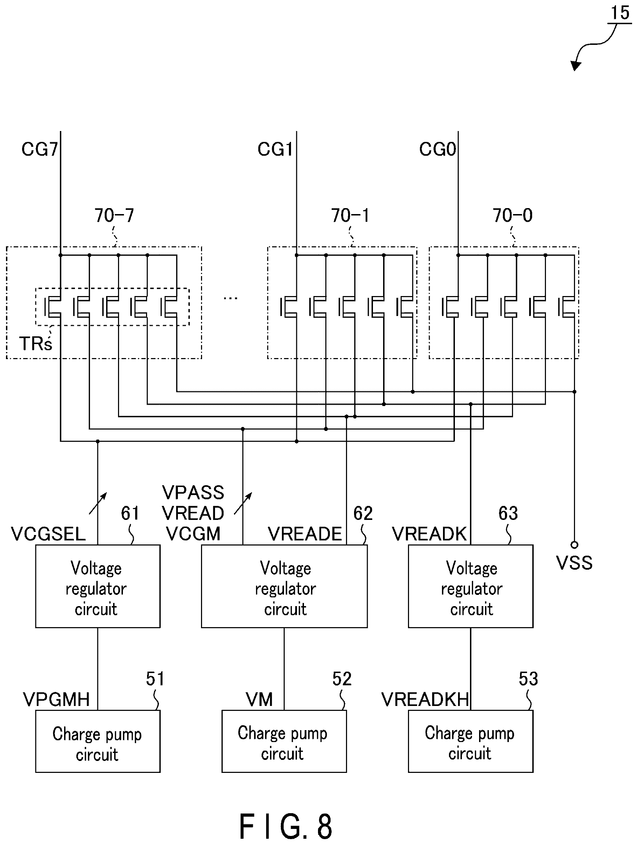

FIG. 8 is a circuit diagram showing an example circuit configuration of the driver module included in the semiconductor memory device according to the first embodiment. FIG. 8 shows a configuration in which voltage is applied to the signal lines CG0 to CG7 in the driver module 15. As illustrated in FIG. 8, the driver module 15 includes charge pump circuits 51, 52, and 53, voltage regulator circuits 61, 62, and 63, and CG select drivers 70-0 to 70-7.

The charge pump circuits 51, 52, and 53 boost an input voltage and output. The charge pump circuit 51 outputs a voltage VPGMH. The voltage VPGMH is a higher voltage than a voltage VPGM described later. The charge pump circuit 52 outputs a voltage VM. The voltage VM is a higher voltage than a voltage VPASS and a voltage VREAD described later. The charge pump circuit 53 outputs a voltage VREADKH. The voltage VREADKH is a higher voltage than a voltage VREADK described later.

The voltage regulator circuits 61, 62, and 63 adjust the voltages input from the charge pump circuits 51, 52, and 53, respectively, to predetermined voltage values, and output the adjusted voltages. The voltage regulator circuit 61 adjusts the voltage VPGMH input from the charge pump circuit 51, and outputs a voltage VCGSEL to be applied to the memory cell transistor MT selected as the target during a read operation or a write operation. The voltage VCGSEL includes a voltage VPGM, read voltages AR, BR, CR, DR, ER, FR, and GR, and verify voltages AV, BV, CV, DV, EV, FV, and GV, which will be described later. That is, the voltage regulator circuit 61 functions as a variable voltage regulator. The voltage regulator circuit 62 adjusts the voltage VM input from the charge pump circuit 52 and outputs voltages VPASS, VREAD, VCGM, and VREADE. For example, the voltages VPASS, VREAD, and VCGM may be output from the same output end. The voltage VREADE is output from another output end different from the voltages VPASS, VREAD, and VCGM. That is, the voltage regulator circuit 62 functions as a variable voltage regulator. The voltage regulator circuit 63 adjusts the voltage VREADKH input from the charge pump circuit 53, and outputs the voltage VREADK described later. Note that the voltages to be output from the voltage regulator circuits 61, 62, and 63 are not limited to those described above.

Each of the CG select drivers 70-0 to 70-7 includes a plurality (five in the example illustrated in FIG. 8) of transistors TRs. Each of the transistors included in the plurality of transistors TRs includes a high-withstand-voltage N-channel MOSFET, for example. Under the control of the sequencer 14, each of the CG select drivers 70-0 to 70-7 transfers a voltage to the corresponding one of the signal lines CG0 to CG7 by selecting one of the transistors TRs and putting the selected transistor TRs into an ON-state. The number of the transistors TRs varies depending on the types of the voltages to be output from the respective voltage regulator circuits 61, 62, and 63.

### 1.1.7 Threshold Distributions of Memory Cell Transistors

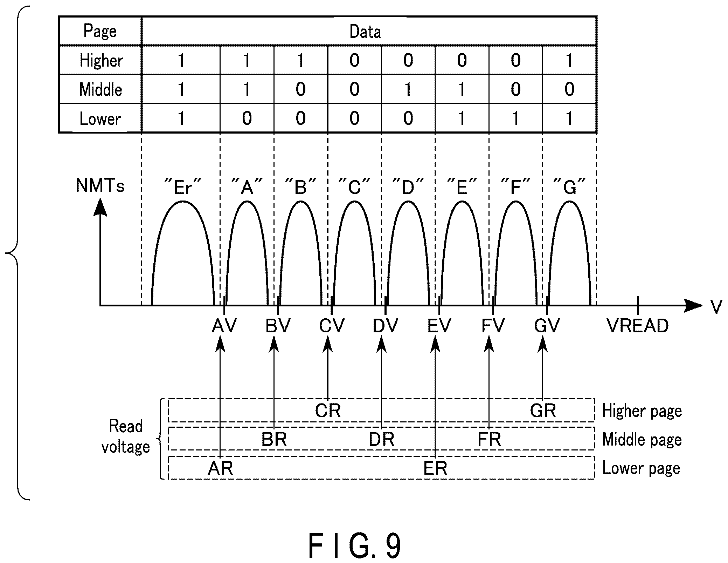

FIG. 9 is a diagram showing an example of the threshold distributions, the read voltages, and the verify voltages of the memory cell transistors in the semiconductor memory device according to the first embodiment. In FIG. 9, the vertical axis corresponds to the number of the memory cell transistors MT (NMTs), and the horizontal axis corresponds to the threshold voltage of the memory cell transistors MT.

As illustrated in FIG. 9, in a case where one memory cell transistor MT is a TLC that memorizes 3-bit data, each of the plurality of memory cell transistors MT included in a cell unit CU form eight types of threshold voltage distributions. Hereinafter, the eight types of threshold distributions (write levels) will be referred to as an "Er" level, an "A" level, a "B" level, a "C" level, a "D" level, an "E" level, an "F" level, and a "G" level in ascending order of threshold voltage.

In a case where a memory cell transistor MT is in an erased state, the threshold voltage of the memory cell transistor MT is included in the "Er" level. In a case where there is data written in a memory cell transistor MT, the threshold voltage of the memory cell transistor MT is included in one of the "Er" to "G" levels. Pieces of 3-bit data different from one another are allocated to the threshold distributions at the "Er" to "G" levels. Allocation of data at each of two adjacent levels is preferably performed in such a manner that only 1-bit data is different. The following is an example of allocation of data to the threshold distributions.

"Er" level: "111 (higher bit/middle bit/lower bit)" data
"A" level: "110" data
"B" level: "100" data
"C" level: "000" data
"D" level: "010" data
"E" level: "011" data
"F" level: "001" data
"G" level: "101" data

Each threshold distribution is defined by the read voltage to be used in a read operation. Specifically, a threshold voltage included in the "Er" level is lower than the read voltage AR. A threshold voltage included in the "A" level is higher than the read voltage AR and is lower than the read voltage BR. A threshold voltage included in the "B" level is higher than the read voltage BR and is lower than the read voltage CR. A threshold voltage included in the "C" level is higher than the read voltage CR and is lower than the read voltage DR. A threshold voltage included in the "D" level is higher than the read voltage DR and is lower than the read voltage ER. A threshold voltage included in the "E" level is higher than the read voltage ER and is lower than the read voltage FR. A threshold voltage included in the "F" level is higher than the read voltage FR and is lower than the read voltage GR. A threshold voltage included in the "G" level is higher than the read voltage GR and is lower than the voltage VREAD described later.

Further, the verify voltages AV, BV, CV, DV, EV, FV, and GV are set to higher voltages than the read voltages AR, BR, CR, DR, ER, FR, and GR, respectively. A verify voltage is a voltage to be used in a data write operation.

The voltage VREAD is set to a higher voltage than the highest threshold distribution (the maximum threshold voltage at the "G" level). As the voltage VREAD is applied to the gate of a memory cell transistor MT, the memory cell transistor MT enters an ON-state, regardless of the data memorized therein.

In a read operation, the semiconductor memory device 3 determines in which threshold distributions the memory cell transistors MT are distributed, using at least one read voltage. For example, 1-page data including lower bits (lower page data) is determined by a read process using the read voltages AR and ER. 1-page data including middle bits (middle page data) is determined by a read process using the read voltages BR, DR, and FR. 1-page data including higher bits (higher page data) is determined by a read process using each of the read voltages CR and GR.

In a write operation, the semiconductor memory device 3 checks whether the threshold voltage of the memory cell transistor MT into which certain data is to be memorized exceeds the verify voltage associated with the data, through a read operation using the verify voltage (hereinafter, referred to as a "verify operation"). If the sequencer 14 detects that the threshold voltage of the memory cell transistor MT exceeds the verify voltage associated with the data, the sequencer 14 completes the write operation into the corresponding memory cell transistor MT.

### 1.2 Operations

The read operation and the write operation to be performed by the semiconductor memory device according to the first embodiment are described. In the following description, a case where the cell unit CU including a memory cell transistor MTk (0 ≤ k ≤ 7) is subjected to reading or writing is described. Hereinafter, the memory cell transistor MTk to be subjected to reading or writing will be referred to as the selected memory cell transistor MTk.

The word line WL coupled to the selected memory cell transistor MTk will be referred to as the selected word line WLk. The word lines WL(k+1) and WL(k-1) adjacent to the selected word line WLk in the Z direction via insulator layers will be referred to as the adjacent word lines WL(k±1). Note that, as for the word line WL0, it is assumed that there is a word line WL (not shown) corresponding to the adjacent word line WL(k-1). As for the word line WL7, it is assumed that there is a word line WL (not shown) corresponding to the adjacent word line WL(k+1). The word lines WL not adjacent to the selected word line WLk in the Z direction via insulator layers will be referred to as the non-adjacent word lines WL(k±i) (i ≥ 2). Note that, in the following description, WL(k±2) will be described as a typical example of the non-adjacent word lines WL(k±i).

Capacitance interference might occur between two word lines WL that are adjacent in the Z direction. For example, in a case where the voltage of one word line WL gradually rises, and the voltage of the other word line WL gradually falls, capacitance interference occurs between both the word lines WL, and a coupling current flows in each of the word lines WL. Since a coupling current acts in a direction of inhibiting a change in voltage, the rate of rise or the rate of fall of both the voltages might become lower at the far end of each word line WL. For example, because of the effect of the coupling current, the time required for the far end of each word line WL to rise or fall to a predetermined voltage can be almost doubled in some cases.

Also, in a case where one word line WL is in a floating state, and the voltage of the other word line WL gradually falls, for example, capacitance interference occurs between both the word lines WL, and a coupling current flows in each of the word lines WL. As a result, the voltage of the word line WL in the floating state might fall.

The signal line CG coupled to the selected word line WLk is referred to as the selected signal line CGk. The signal lines CG(k+1) and CG(k-1) coupled to the adjacent word lines WL(k±1) are referred to as the adjacent signal lines CG(k±1). The signal lines CG(k+2) and CG(k-2) coupled to the non-adjacent word lines WL(k±2) are referred to as the non-adjacent signal lines CG(k±2).

### 1.2.1 Read Operation

An example read operation in the semiconductor memory device 3 according to the first embodiment is now described, with a read operation of reading lower page data being a typical example among page-by-page read operations.

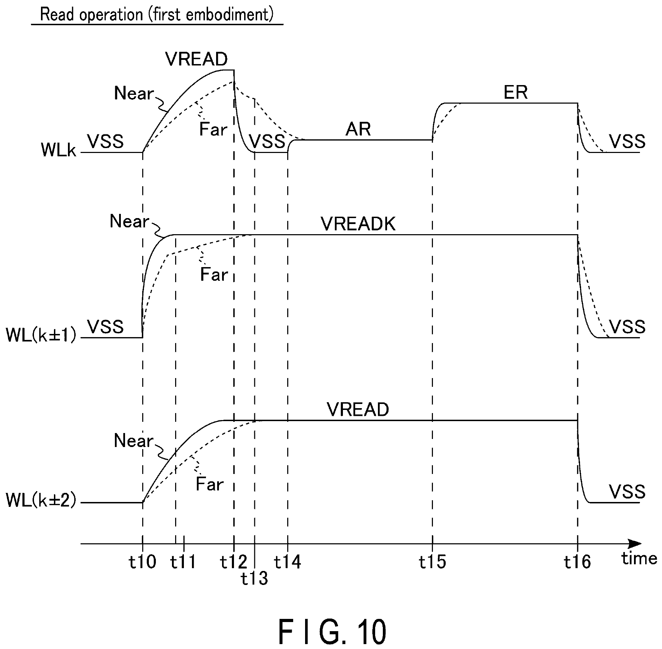

FIG. 10 is a timing chart showing an example read operation of reading lower page data in the semiconductor memory device according to the first embodiment. Note that, as for the voltage of each word line WL, the voltage at the near end (Near) is indicated by a solid line, and the voltage at the far end (Far) is indicated by a dashed line.

As illustrated in FIG. 10, at the start of the read operation, the voltage of each of the selected word line WLk, the adjacent word lines WL(k±1), and the non-adjacent word lines WL(k±2) is a voltage VSS. The voltage VSS is a ground voltage, for example.

At the start of the read operation of reading lower page data, for example, in the period from time t10 to time t14, the sequencer 14 performs an operation of removing residual electrons in the channel in the selected memory cell transistor MTk. In the period from time t14 to time t15, the sequencer 14 performs a read process using the read voltage AR. In the period from time t15 to time t16, the sequencer 14 performs a read process using the read voltage ER.

At time t10, the voltage VREAD is applied to the selected signal line CGk and the non-adjacent signal lines CG(k±2).

For example, the voltage at the near end (Near) of each of the selected word line WLk and the non-adjacent word lines WL(k±2) gradually rises, and reaches the voltage VREAD at time t12. The voltage at the far end (Far) of each of the selected word line WLk and the non-adjacent word lines WL(k±2) rises with a delay from that at the near end (Near).

On the other hand, at time t10, the voltage VREADK is applied to the adjacent signal lines CG(k±1). The voltage VREADK is a voltage that is higher than the voltage VREAD, and is lower than the voltage VPGM described later.

The voltage regulator circuit 63 that generates the voltage VREADK to be applied to the adjacent signal lines CG(k±1) is coupled to the charge pump circuit 53. On the other hand, the voltage regulator circuit 62 that generates the voltage VREAD to be applied to the selected signal line CGk and the non-adjacent signal lines CG(k±2) is coupled to the charge pump circuit 52. While the charge pump circuit 52 supplies current to a large number of signal lines, the charge pump circuit 53 supplies current only to the two signal lines of the adjacent signal lines CG(k±1). Accordingly, the current to be supplied to each of the adjacent signal lines CG(k±1) can be larger than the current to be supplied to each of the selected signal line CGk and the non-adjacent signal lines CG(k±2). That is, it can be said that the charge pump circuit 53 has a higher current supply capability per signal line CG than the charge pump circuit 52. Therefore, the adjacent word lines WL(k±1) have a higher rate of voltage rise and a steeper slope than those of the selected word line WLk and the non-adjacent word lines WL(k±2). Accordingly, at time t11 earlier than time t12 when the near ends (Near) of the selected word line WLk and the non-adjacent word lines WL(k±2) reach the voltage VREAD, the near ends (Near) of the adjacent word lines WL(k±1) reach the voltage VREADK. The voltage at the far ends (Far) of the adjacent word lines WL(k±1) rises with a delay from that at the near ends (Near).

As the voltage of the adjacent word lines WL(k±1) is set to the voltage VREADK, it is possible to reduce the influence of the voltage fall due to the interference of the low voltage (the read voltage AR, for example) applied to the selected word line WLk when the read process is executed. There is a possibility that the gate voltage of the memory cell transistor MT will be subjected to interference of the voltage of the word lines WL coupled to the gates of the memory cell transistors MT that are adjacent in the Z direction. Specifically, there is a possibility that the voltage to be applied to the gate of each memory cell transistor MT(k±1) falls below the voltage of each of the adjacent word lines WL(k±1), due to the interference of the low voltage applied to the selected word line WLk. As the voltage of the adjacent word lines WL(k±1) is set to the voltage VREADK, the fall in voltage due to the interference of the low voltage to be applied to the selected word line WLk with the memory cell transistors MT(k±1) is canceled by the rise to the voltage VREADK from the voltage VREAD (VREADK - VREAD). Accordingly, when the read process is performed, it is possible to prevent the voltage of the adjacent word lines WL(k±1) from falling below the highest threshold distribution (the maximum threshold voltage at the "G" level) due to the voltage fall caused by the interference of the low voltage to be applied to the selected word line WLk.

After the voltage at the near end (Near) of the selected word line WLk has reached the voltage VREAD, the voltage to be applied to the selected signal line CGk is lowered to the voltage VSS at time t12. Note that the voltage to be applied to the selected signal line CGk may be lowered to the voltage VSS before the voltages at the far ends (Far) of the selected word line WLk and the non-adjacent word lines WL(k±2) reach the voltage VREAD.

For example, the voltage at the near end (Near) of the selected word line WLk falls sharply to the voltage VSS. In the period from time t12 to time t13, the voltage at the far end (Far) of the selected word line WLk is affected by the coupling current caused by the capacitance interference between the selected word line WLk and the adjacent word lines WL(k±1), and falls slowly with a delay from that at the near end (Near). After time t13, the voltage at the far end (Far) of the selected word line WLk falls to the neighborhood of the read voltage AR at a higher rate than that in the period from time t12 to time t13.

After that, at time t14, the voltage to be applied to the selected signal line CGk is raised to the read voltage AR.

For example, the voltage at the near end (Near) of the selected word line WLk gradually rises to the read voltage AR. The voltage at the far end (Far) of the selected word line WLk continues to fall, and converges to the read voltage AR. Note that the voltage at the far end (Far) of the selected word line WLk may once become lower than the read voltage AR, and then rise to the read voltage AR together with the voltage at the near end (Near).

After that, the sense amplifier module 17 determines the data memorized in the selected memory cell transistor MTk. Specifically, the sense amplifier module 17 determines whether the threshold voltage of the selected memory cell transistor MTk is higher than the read voltage AR or not, and memorizes the determination result into the latch circuit included in the sense amplifier module 17.

Next, at time t15, the voltage to be applied to the selected signal line CGk is raised to the read voltage ER.

For example, the voltage at the near end (Near) of the selected word line WLk gradually rises to the read voltage ER. The voltage at the far end (Far) of the selected word line WLk gradually rises to the read voltage ER, with a delay from that at the near end (Near).

After that, the sense amplifier module 17 determines the data memorized in the selected memory cell transistor MTk. Specifically, the sense amplifier module 17 determines whether the threshold voltage of the selected memory cell transistor MTk is higher than the read voltage ER or not. The sequencer 14 determines the lower page data, based on this determination result and the determination result memorized in the latch circuit included in the sense amplifier module 17. The determined lower page data is memorized into the latch circuit included in the sense amplifier module 17, for example.

Lastly, at time t16, the voltage VSS is applied to the selected signal line CGk, the adjacent signal lines CG(k±1), and the non-adjacent signal lines CG(k±2). As a result, the voltages of the selected word line WLk, the adjacent word lines WL(k±1), and the non-adjacent word lines WL(k±2) fall to the voltage VSS, and return to the state before the read operation.

In the above manner, the semiconductor memory device 3 according to the first embodiment can perform a read operation of reading lower page data. Note that the semiconductor memory device 3 according to the first embodiment can perform each read operation of reading middle page data and upper page data in a manner similar to that in the read operation of reading lower page data. After that, the sense amplifier module 17 performs an arithmetic process using the determined lower page data, middle page data, and upper page data, and transfers the determination results as read data DAT to the input/output circuit 11.

### 1.2.2 Write Operation

An example write operation in the semiconductor memory device 3 according to the first embodiment is now described.

### 1.2.2.1 Write Order

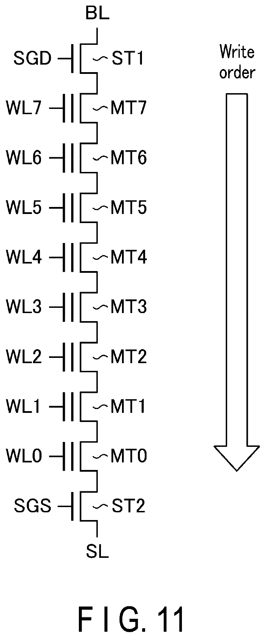

FIG. 11 is a diagram showing an example of the order of data write in a NAND string included in the semiconductor memory device according to the first embodiment. Referring to FIG. 11, the order of data write in a NAND string NS is described.

As illustrated in FIG. 11, when a write operation is performed, the memory cell transistors MT are sequentially selected as the write target, starting from the memory cell transistor MT on the side of the bit line BL.

In the example illustrated in FIG. 11, the sequencer 14 first selects the memory cell transistor MT7 as the write target. After that, the sequencer 14 sequentially selects the memory cell transistors MT6 to MT1, and lastly selects the memory cell transistor MT0. In other words, the sequencer 14 first selects the word line WL7 as the selected word line, then selects the word lines WL6 to WL1 in this order, and lastly selects the word line WL0.

In the description below, a case where writing is sequentially performed, starting from the memory cell transistor MT on the side of the bit line BL as illustrated in FIG. 11, will be explained. That is, in a case where the memory cell transistor MTk is selected, some kind of data has been written into the memory cell transistors MT(k+1), MT(k+2), ..., and MT7. No data has been written into the memory cell transistors MT(k-1), MT(k-2), ..., and MT0 (an erased state). Except for the cases where k = 0 or k = 7, the selected word line WLk is provided so as to be sandwiched in the Z direction by the adjacent word line WL(k+1) coupled to the memory cell transistor MT(k+1) in which data has already been written and the adjacent word line WL(k-1) coupled to the memory cell transistor MT(k-1) in which data has not yet been written. Hereinafter, the adjacent word line WL(k+1) coupled to the memory cell transistor MT(k+1) in which data has already been written will be referred to specifically as the written adjacent word line WL(k+1). The adjacent word line WL(k-1) coupled to the memory cell transistor MT(k-1) in which data has not yet been written will be referred to specifically as the unwritten adjacent word line WL(k-1).

The signal line CGk coupled to the selected word line WLk will be referred to as the selected signal line CGk. The signal line CG(k+1) coupled to the written adjacent word line WL(k+1) will be referred to as the written adjacent signal line CG(k+1). The signal line CG(k-1) coupled to the unwritten adjacent word line WL(k-1) will be referred to as the unwritten adjacent signal line CG(k-1). The signal lines CG(k+2) and CG(k-2) coupled to the non-adjacent word lines WL(k±2) are referred to as the non-adjacent signal lines CG(k±2).

### 1.2.2.2 Program Loop

The semiconductor memory device 3 repeatedly executes a program loop in a write operation. Each program loop includes a program operation and a verify operation. In the program operation, the voltage VPGM is applied to the selected word line WLk. The voltage VPGM is a high voltage that can cause the threshold voltage of the selected memory cell transistor MTk to rise. Accordingly, the threshold voltage of the selected memory cell transistor MTk rises. In the verify operation, a check is made to determine whether the threshold voltage of the selected memory cell transistor MTk exceeds the verify voltage applied to the selected word line WLk or not. In the write operation, a program loop including the program operation and the verify operation is repeatedly executed a plurality of times.

In the description below, an example write operation in the semiconductor memory device 3 according to the first embodiment is explained, with a typical example being a program loop in which the "A" level and the "B" level are set as verify targets in the verify operation.

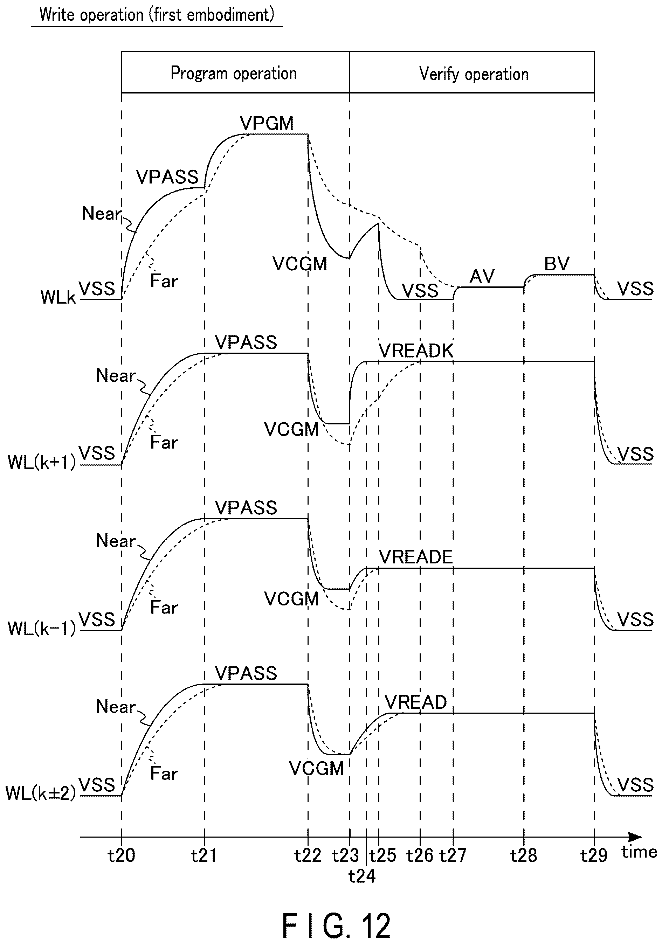

FIG. 12 is a timing chart showing an example write operation in the semiconductor memory device according to the first embodiment. FIG. 12 shows a write operation in a program loop in which the "A" level and the "B" level are set as verify targets in the verify operation. Note that, as for the voltage of each word line WL, the voltage at the near end (Near) is indicated by a solid line, and the voltage at the far end (Far) is indicated by a dashed line in FIG. 12.

When the program loop is started, the sequencer 14 performs the program operation in the period from time t20 to time t23, for example. The verify operation is performed in the period from time t23 to time t29. In particular, in the period from time t27 to time t28, verification using the verify voltage AV is performed. In the period from time t28 to time t29, verification using the verify voltage BV is performed. The period from time t23 to time t27 is a period for adjusting the voltage level for performing the verify operation.

As illustrated in FIG. 12, at the start of the program loop, the voltage of each of the selected word line WLk, the written adjacent word line WL(k+1), the unwritten adjacent word line WL(k-1), and the non-adjacent word lines WL(k±2) is the voltage VSS, for example.

At time t20, the voltage VPASS is applied to the selected signal line CGk, the written adjacent signal line CG(k+1), the unwritten adjacent signal line CG(k-1), and the non-adjacent signal lines CG(k±2). The voltage VPASS is a voltage that is lower than the voltage VPGM and puts the memory cell transistor MT into an ON-state, regardless of the threshold voltage of the memory cell transistor MT.

For example, the voltage at the near end (Near) of each of the selected word line WLk, the written adjacent word line WL(k+1), the unwritten adjacent word line WL(k-1), and the non-adjacent word lines WL(k±2) gradually rises, and reaches the voltage VPASS. The voltage at the far end (Far) of each of the selected word line WLk, the written adjacent word line WL(k+1), the unwritten adjacent word line WL(k-1), and the non-adjacent word lines WL(k±2) rises with a delay from that at the near end (Near).

Next, at time t21, the voltage VPGM is applied to the selected signal line CGk.

For example, the voltage at the near end (Near) of the selected word line WLk gradually rises, and reaches the voltage VPGM. The voltage at the far end (Far) of the selected word line WLk rises with a delay from that at the near end (Near).

If the voltage of the selected word line WLk reaches the voltage VPGM in the period from time t21 to time t22, the potential difference between the selected word line WLk and the channel (to which the voltage VSS is applied via the corresponding bit line BL, for example) (VPGM - VSS) becomes larger in the selected memory cell transistor MTk to be programmed. As a result, electrons are trapped in the charge storage film, and the threshold voltage of the selected memory cell transistor MTk is raised. On the other hand, in the selected memory cell transistor MTk prohibited from being programmed, the potential difference between the selected word line WLk and the channel (a voltage of a predetermined magnitude is applied via the corresponding bit line BL, for example) is smaller than that of that in the selected memory cell transistor MTk to be programmed. As a result, electrons are not trapped in the charge memory film due to a self-boost effect, and the threshold voltage of the selected memory cell transistor MTk is maintained.

Next, at time t22, the voltage VCGM is applied to the selected signal line CGk, the written adjacent signal line CG(k+1), the unwritten adjacent signal line CG(k-1), and the non-adjacent signal lines CG(k±2). The voltage VCGM is higher than the voltage VSS, and is lower than the voltage VPASS and the voltage VREAD.

For example, the voltage at the near end (Near) of the selected word line WLk falls sharply, and reaches a voltage in the neighborhood of the voltage VCGM at time t23. The voltage at the far end (Far) of the selected word line WLk has a delay from that at the near end (Near) immediately after the voltage application, and falls while being affected by the coupling current caused by the capacitance interference between the selected word line WLk and the adjacent word lines WL(k±1).

The voltage at the near end (Near) of each of the written adjacent word line WL(k+1) and the unwritten adjacent word line WL(k-1) falls sharply, and reaches the voltage VCGM before time t23. The voltage at the far end (Far) of each of the written adjacent word line WL(k+1) and the unwritten adjacent word line WL(k-1) is affected by the coupling current caused by the capacitance interference between the written adjacent word line WL(k+1) and the selected word line WLk, falls sharply, and can have a lower voltage than the voltage VCGM.

The voltage at the near end (Near) of the non-adjacent word lines WL(k±2) falls sharply, and reaches the voltage VCGM. The voltage at the far ends (Far) of the non-adjacent word lines WL(k±2) falls with a delay from that at the near ends (Near).

Next, at time t23, the voltage VREAD is applied to the selected signal line CGk and the non-adjacent signal lines CG(k±2). The voltage VREADK is applied to the written adjacent signal line CG(k+1). The voltage VREADE is applied to the unwritten adjacent signal line CG(k-1). The voltage VREADE is a voltage that is lower than the voltage VREAD, and is higher than the lowest threshold distribution (the maximum threshold voltage at the "Er" level). Each memory cell transistor MT in an erased state (in which no data has been written) enters an ON-state when the voltage VREADE is applied to the gate thereof.

The voltage regulator circuit 63 that generates the voltage VREADK to be applied to the written adjacent signal line CG(k+1) is coupled to the charge pump circuit 53. On the other hand, the voltage regulator circuit 62 that generates the voltage VREAD to be applied to the selected signal line CGk and the non-adjacent signal lines CG(k±2), and the voltage VREADE to be applied to the unwritten adjacent signal line CG(k-1) is coupled to the charge pump circuit 52. While the charge pump circuit 52 supplies current to a large number of signal lines, the charge pump circuit 53 supplies current only to the one signal line of the written adjacent signal line CG(k+1). Accordingly, the current to be supplied to the written adjacent signal line CG(k+1) can be larger than the current to be supplied to each of the selected signal line CGk, the unwritten adjacent signal line CG(k-1), and the non-adjacent signal lines CG(k±2). That is, it can be said that the charge pump circuit 53 has a higher current supply capability per signal line CG than the charge pump circuit 52. Because of this, the written adjacent word line WL(k+1) has a higher rate of voltage rise and a steeper slope than those of the selected word line WLk, the unwritten adjacent word line WL(k-1), and the non-adjacent word lines WL(k±2). Accordingly, the voltage at the near end (Near) of the written adjacent word line WL(k+1) reaches the voltage VREADK at time t24, for example. The voltage at the far end (Far) of the written adjacent word line WL(k+1) has a delay from that at the near end (Near), and rises slowly, being affected by the coupling current caused by the capacitance interference between the written adjacent word line WL(k+1) and the selected word line WLk.

After time t23, the voltages at the near ends (Near) of the selected word line WLk, the unwritten adjacent word line WL(k-1), and the non-adjacent word lines WL(k±2) rise at substantially the same rate (slope). Accordingly, the unwritten adjacent word line WL(k-1) having the lower voltage applied thereto reaches the voltage VREADE first. The voltage at the far end (Far) of each of the selected word line WLk, the unwritten adjacent word line WL(k-1), and the non-adjacent word lines WL(k±2) rises with a delay from that at the near end (Near). For example, the far end (Far) of the unwritten adjacent word line WL(k-1) reaches the voltage VREADE.

As the voltage of the selected word line WLk rises, residual electrons in the channel in the selected memory cell transistor MTk are removed, and appropriate verification can be performed.

After that, at time t25, the voltage VSS is applied to the selected signal line CGk.

After time t25, being affected by the coupling current caused by the capacitance interference between the written adjacent word line WL(k+1) and the selected word line WLk, the voltage at the far end (Far) of the written adjacent word line WL(k+1) rises at a slower rate, and reaches the voltage VREADK at time t26.

The voltage at the near end (Near) of the selected word line WLk falls sharply, and reaches the voltage VSS. In the period from time t25 to time t26, the voltage at the far end (Far) of the selected word line WLk falls slowly, being affected by the coupling current caused by the capacitance interference between the selected word line WLk and the written adjacent word line WL(k+1). After time t26, the influence of the coupling current is small, and accordingly, the voltage falls to the neighborhood of the verify voltage AV at a higher rate.

As the voltage of the written adjacent word line WL(k+1) is set to the voltage VREADK, it is possible to cancel the voltage fall caused by the interference of the low voltage (the verify voltage AV, for example) to be applied to the selected word line WLk when the verify operation is performed. There is a possibility that the memory cell transistor MT will be subjected to interference of the voltage of the word lines WL coupled to the gates of the memory cell transistors MT that are adjacent in the Z direction. Specifically, there is a possibility that the voltage to be applied to the gate of each memory cell transistor MT(k+1) falls below the voltage of each adjacent word line WL(k+1), due to the interference of the low voltage applied to the selected word line WLk. As the voltage of the adjacent word line WL(k+1) is set to the voltage VREADK, the voltage fall caused by the voltage fall effect the low voltage to be applied to the selected word line WLk has on the memory cell transistor MT(k+1) is canceled by the rise to the voltage VREADK from the voltage VREAD (VREADK - VREAD). Accordingly, when the verify operation is performed, it is possible to prevent the voltage of the written adjacent word line WL(k+1) from falling below the highest threshold distribution (the maximum threshold voltage at the "G" level) due to the voltage fall caused by the action of the low voltage to be applied to the selected word line WLk.

After that, at time t27, the verify voltage AV is applied to the selected signal line CGk.

For example, the voltage at the near end (Near) of the selected word line WLk gradually rises to the verify voltage AV. The voltage at the far end (Far) of the selected word line WLk continues to fall, and converges to the verify voltage AV. Note that the voltage at the far end (Far) of the selected word line WLk may once become lower than the verify voltage AV, and then rise to the verify voltage AV together with the voltage at the near end (Near).

After that, the sense amplifier module 17 determines the data memorized in the selected memory cell transistor MTk, which is the verify target. Specifically, the sense amplifier module 17 determines whether the threshold voltage of the selected memory cell transistor MTk is equal to or higher than the verify voltage AV or not, and memorizes the determination result into the latch circuit included in the sense amplifier module 17.

Next, at time t28, the voltage to be applied to the selected signal line CGk is raised to the verify voltage BV.

For example, the voltage at the near end (Near) of the selected word line WLk gradually rises to the verify voltage BV. The voltage at the far end (Far) of the selected word line WLk gradually rises to the verify voltage BV, with a delay from that at the near end (Near).

After that, the sense amplifier module 17 determines the data memorized in the selected memory cell transistor MTk. Specifically, the sense amplifier module 17 determines whether the threshold voltage of the selected memory cell transistor MTk is equal to or higher than the verify voltage BV or not. The sequencer 14 determines the verification result, based on this determination result and the determination result memorized in the latch circuit included in the sense amplifier module 17. The determined verification result is memorized into the latch circuit included in the sense amplifier module 17, for example.

Lastly, at time t29, the voltage VSS is applied to the selected signal line CGk, the written adjacent word line WL(k+1), the unwritten adjacent word line WL(k-1), and the non-adjacent signal lines CG(k±2). As a result, the voltages of the selected word line WLk, the written adjacent word line WL(k+1), the unwritten adjacent word line WL(k-1), and the non-adjacent word lines WL(k±2) fall to the voltage VSS, and return to the state at the time of the start of the program loop.

In the above manner, the semiconductor memory device 3 according to the first embodiment executes one program loop. After that, whether or not to execute the program loop next time is determined based on the verification result, and, in a case where the program loop is to be executed, the selected memory cell transistor MTk to be programmed and the selected memory cell transistors MTk to be prohibited from being programmed in the next program loop are determined. By executing the program loop a plurality of times, the semiconductor memory device 3 according to the first embodiment can complete the write operation.

### 1.3 Effects

The semiconductor memory device according to the present embodiment can shorten the processing times required for reading and writing data from and into a memory cell. The effects are described in detail below.

### 1.3.1 Effects in a Read Operation

In a read operation, in the period from the time (t12) when the voltage of the selected word line WLk starts falling to the voltage VSS to the time (t13) when the voltage rise at the far ends (Far) of the adjacent word lines WL(k±1) comes to an end (from t12 to t13), the voltage of the adjacent word lines WL(k±1) rises, and the voltage of the selected word line WLk falls. Therefore, a coupling current accompanying the capacitance interference between the two voltages is generated. The coupling current inhibits a rise in the voltage of the adjacent word lines WL(k±1), and inhibits a fall in the voltage of the selected word line WLk.

In a read operation in the semiconductor memory device 3 according to the first embodiment, the rate at which the voltage of the adjacent word lines WL(k±1) rises to the voltage VREADK is higher than the rate at which the voltages of the selected word line WLk and the non-adjacent word lines WL(k±2) rise to the voltage VREAD, as illustrated FIG. 10. Thus, the time at which the voltage at the far ends (Far) of the adjacent word lines WL(k±1) reaches the voltage VREADK can be advanced. After that, at the time (t12) when the voltage VSS is applied to the selected word line WLk, the voltage at the far end (Far) of the adjacent word lines WL(k±1) rises to the neighborhood of the voltage VREADK. Accordingly, the period from the time (t12) when the voltage of the selected word line WLk starts falling to the voltage VSS to the time (t13) when the far end (Far) of the adjacent word lines WL(k±1) reaches the voltage VREADK (from t12 to t13) can be shortened. Thus, the period during which the coupling current flows can be shortened, and the rate at which the voltage at the far end (Far) of the selected word line WLk falls can be increased.

As described above, the time at which the voltage at the far end (Far) of the selected word line WLk reaches a read voltage (the read voltage AR, for example) is advanced. Accordingly, a read process can be started at an earlier time, and thus, the time required for the entire read operation can be shortened.

### 1.3.2 Effects in a Write Operation

In a write operation, in the period from the time (t25) when the voltage of the selected word line WLk starts falling to the voltage VSS to the time (t26) when the voltage rise at the far ends (Far) of both the written adjacent word line WL(k+1) and the unwritten adjacent word line WL(k-1) comes to an end (from t25 to t26), the voltage of the written adjacent word line WL(k+1) and the unwritten adjacent word line WL(k-1) rises, and the voltage of the selected word line WLk falls. Therefore, a coupling current accompanying the capacitance interference between the two voltages is generated. The coupling current inhibits a rise in the voltage of the written adjacent word line WL(k+1) and the unwritten adjacent word line WL(k-1), and inhibits a fall in the voltage of the selected word line WLk.

In a write operation in the semiconductor memory device 3 according to the first embodiment, the rate at which the voltage of the written adjacent word line WL(k+1) rises to the voltage VREADK is higher than the rate at which the voltages of the selected word line WLk and the non-adjacent word lines WL(k±2) rise to the voltage VREAD, as illustrated FIG. 12. Accordingly, the time at which the voltage at the far ends (Far) of the written adjacent word line WL(k+1) reaches the voltage VREADK can be advanced. After that, at the time (t25) when the voltage VSS is applied to the selected word line WLk, the voltage at the far end (Far) of the written adjacent word line WL(k+1) rises to the neighborhood of the voltage VREADK. Accordingly, the period from the time (t25) when the voltage of the selected word line WLk starts falling to the voltage VSS to the time (t26) when the far end (Far) of the written adjacent word line WL(k+1) reaches the voltage VREADK (from t25 to t26) can be shortened. Thus, the period during which the coupling current flows can be shortened, and the rate at which the voltage at the far end (Far) of the selected word line WLk falls to the voltage VSS can be increased.

Further, the time till the voltage of the unwritten adjacent word line WL(k-1) rises to the voltage VREADE is shorter than the time till the voltages of the selected word line WLk and the non-adjacent word lines WL(k±2) rise to the voltage VREAD. Accordingly, the time at which the voltage at the far end (Far) of the unwritten adjacent word line WL(k-1) reaches the voltage VREADE can be advanced. After that, at the time (t25) when the voltage VSS is applied to the selected word line WLk, the voltage at the far end (Far) of the unwritten adjacent word line WL(k-1) rises to the neighborhood of the voltage VREADE. Accordingly, the period from the time when the voltage of the selected word line WLk starts falling to the voltage VSS to the time when the far end (Far) of the unwritten adjacent word line WL(k-1) reaches the voltage VREADE can be shortened. Thus, the period during which the coupling current flows can be shortened, and the rate at which the voltage at the far end (Far) of the selected word line WLk falls can be increased.

Note that no data has been written into the memory cell transistor MT(k-1) (in an erased state) having the unwritten adjacent word line WL(k-1) coupled to the gate thereof. Therefore, even if the voltage VREADE is applied instead of the voltage VREAD in the verify operation, the memory cell transistor MT(k-1) is in an ON-state. Accordingly, the verify operation is not inhibited.

As described above, the time at which the voltage at the far end (Far) of the selected word line WLk reaches a verify voltage (the verify voltage AV, for example) is advanced. Accordingly, the verify operation can be started at an earlier time, and thus, the time required for the entire write operation can be shortened.

### 2. Second Embodiment

Next, a semiconductor memory device according to a second embodiment is described. In a read operation, a semiconductor memory device 3 according to the second embodiment performs an operation different from that by the semiconductor memory device 3 according to the first embodiment. In the description below, explanation of configurations and operations similar to those of the first embodiment will not be repeated, and operations different from those of the first embodiment will be mainly explained.

### 2.1 Read Operation

An example read operation in the semiconductor memory device 3 according to the second embodiment is now described, with a read operation of reading lower page data being a typical example among page-by-page read operations.

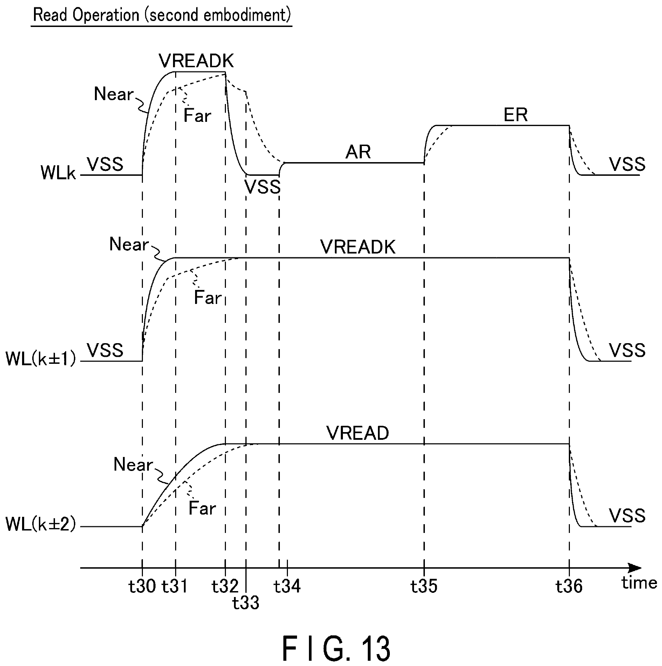

FIG. 13 is a timing chart showing an example read operation of reading lower page data in the semiconductor memory device according to the second embodiment. Note that, as for the voltage of each word line WL, the voltage at the near end (Near) is indicated by a solid line, and the voltage at the far end (Far) is indicated by a dashed line.

As illustrated in FIG. 13, at the start of the read operation, the voltage of each of the selected word line WLk, the adjacent word lines WL(k±1), and the non-adjacent word lines WL(k±2) is the voltage VSS, for example.

At time t30, the voltage VREAD is applied to the non-adjacent signal lines CG(k±2).

For example, the voltage at the near ends (Near) of the non-adjacent word lines WL(k±2) gradually rises, and reaches the voltage VREAD at time t32. The voltage at the far ends (Far) of the non-adjacent word lines WL(k±2) rises with a delay from that at the near ends (Near).

On the other hand, at time t30, the voltage VREADK is applied to the selected signal line CGk and the adjacent signal lines CG(k±1).

The voltage regulator circuit 63 that generates the voltage VREADK to be applied to the selected signal line CGk and the adjacent signal lines CG(k±1) is coupled to the charge pump circuit 53. On the other hand, the voltage regulator circuit 62 that generates the voltage VREAD to be applied to the non-adjacent signal lines CG(k±2) is coupled to the charge pump circuit 52. While the charge pump circuit 52 supplies current to a large number of signal lines, the charge pump circuit 53 supplies current only to the three signal lines of the selected signal line CGk and the adjacent signal lines CG(k±1). Accordingly, the current to be supplied to each of the adjacent signal lines CG(k±1) can be larger than the current to be supplied to each of the non-adjacent signal lines CG(k±2). That is, it can be said that the charge pump circuit 53 has a higher current supply capability per signal line CG than the charge pump circuit 52. Therefore, the selected word line WLk and the adjacent word lines WL(k±1) have a higher rate of voltage rise and a steeper slope than those of the non-adjacent word lines WL(k±2). Accordingly, at time t31 earlier than time t32 at which the near ends (Near) of the non-adjacent word lines WL(k±2) reach the voltage VREAD, the near end (Near) of each of the selected word line WLk and the adjacent word lines WL(k±1) reaches the voltage VREADK. The voltage at the far end (Far) of each of the selected word line WLk and the adjacent word lines WL(k±1) rises with a delay from that at the near end (Near).

The operation from time t32 to time t36 is the same as the operation from time t12 to time t16 of the first embodiment.

### 2.2 Effects

The semiconductor memory device 3 according to the second embodiment can shorten the processing time required for a read operation of reading data from a memory cell, as in the first embodiment.

Further, in the semiconductor memory device 3 according to the second embodiment, at the time of the read operation, the selected word line WLk, together with the adjacent word lines WL(k±1), rises to the voltage VREADK at the same rate. Thus, it is possible to suppress capacitance interference that might occur between the selected word line WLk and the adjacent word lines WL(k±1) at the time of a voltage rise. As a result, the time required for a voltage rise can be shortened, and the processing time required for the entire read operation can be shortened.

Additionally, if the potentials are different between adjacent word lines, gate induced drain leakage (GIDL) might occur. If GIDL occurs, hot carrier injection (HCI) occurs in the charge storage film due to a high field effect, which might lead to rewriting of data memorized in a memory cell transistor MT or deterioration of the circuit characteristics of the memory cell transistors MT. That is, the occurrence of GIDL leads to a decrease in the reliability of the semiconductor memory device 3.

In the semiconductor memory device 3 according to the second embodiment, at the time of the read operation, the selected word line WLk, together with the adjacent word lines WL(k±1), rises to the voltage VREADK at the same rate. As a result, the potential difference between the selected word line WLk and the adjacent word lines WL(k±1) becomes smaller. Thus, it is possible to suppress the occurrence of GIDL in the vicinity of the selected word line WLk, and suppress hot carrier injection. Accordingly, a decrease in the reliability of the semiconductor memory device 3 can be prevented.

### 3. Third Embodiment

Next, a semiconductor memory device according to a third embodiment is described. In a read operation, a semiconductor memory device 3 according to the third embodiment performs an operation different from that by the semiconductor memory device 3 according to the second embodiment. In the description below, explanation of configurations and operations similar to those of the second embodiment will not be repeated, and operations different from those of the second embodiment will be mainly explained.

### 3.1 Circuit Configuration of a Driver Module

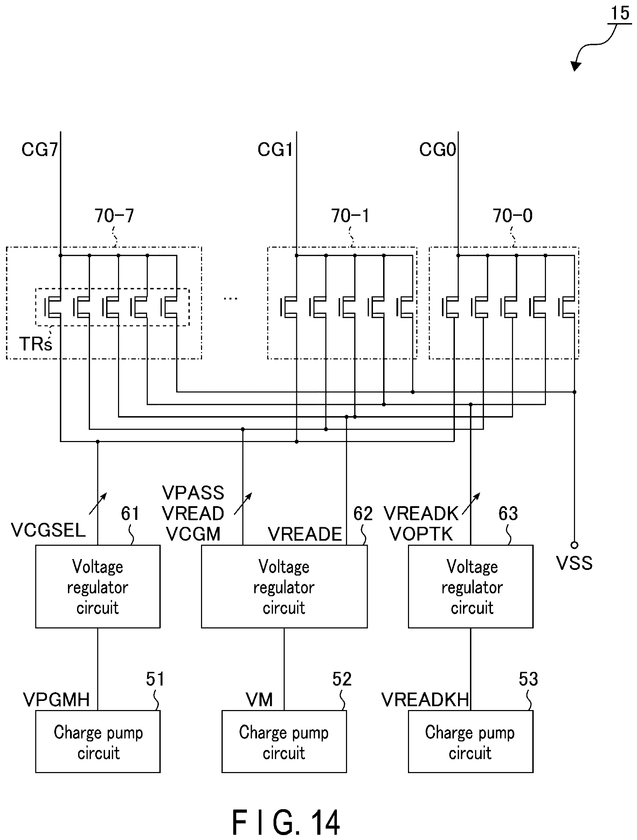

FIG. 14 is a circuit diagram showing an example circuit configuration of a driver module included in the semiconductor memory device according to the third embodiment.

As illustrated in FIG. 14, in the driver module 15 included in the semiconductor memory device 3 according to the third embodiment, the voltage regulator circuit 63 further generates a voltage VOPTK. The voltage VOPTK is a voltage that is higher than the highest threshold distribution (the maximum threshold at the "G" level), and is lower than the voltage VREADK. The voltage regulator circuit 63 outputs the voltage VOPTK from the same output end as the voltage VREADK, for example. That is, the voltage regulator circuit 63 functions as a variable voltage regulator.

### 3.2 Read Operation

An example read operation in the semiconductor memory device 3 according to the third embodiment is now described, with a read operation of reading lower page data being a typical example among page-by-page read operations.

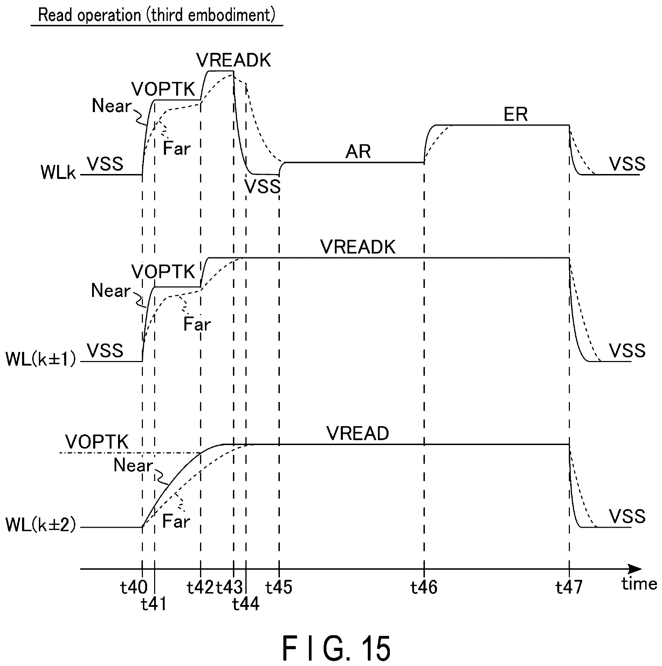

FIG. 15 is a timing chart showing an example read operation of reading lower page data in the semiconductor memory device according to the third embodiment. Note that, as for the voltage of each word line WL, the voltage at the near end (Near) is indicated by a solid line, and the voltage at the far end (Far) is indicated by a dashed line.

As illustrated in FIG. 15, at the start of the read operation, the voltage of each of the selected word line WLk, the adjacent word lines WL(k±1), and the non-adjacent word lines WL(k±2) is the voltage VSS, for example.

At time t40, the voltage VREAD is applied to the non-adjacent signal lines CG(k±2).

For example, the voltage at the near ends (Near) of the non-adjacent word lines WL(k±2) gradually rises, and reaches the voltage VREAD at time t43. The voltage at the far ends (Far) of the non-adjacent word lines WL(k±2) rises with a delay from that at the near ends (Near).

On the other hand, at time t40, the voltage VOPTK is applied to the selected signal line CGk and the adjacent signal lines CG(k±1).

The voltage regulator circuit 63 that generates the voltage VOPTK to be applied to the selected signal line CGk and the adjacent signal lines CG(k±1) is coupled to the charge pump circuit 53. On the other hand, the voltage regulator circuit 62 that generates the voltage VREAD to be applied to the non-adjacent signal lines CG(k±2) is coupled to the charge pump circuit 52. While the charge pump circuit 52 supplies current to non-adjacent signal lines CG(k±i) (i being an integer of 2 or greater), the charge pump circuit 53 supplies current only to the three signal lines of the selected signal line CGk and the adjacent signal lines CG(k±1). Accordingly, the current to be supplied to each of the selected signal line CGk and the adjacent signal lines CG(k±1) can be larger than the current to be supplied to each of the non-adjacent signal lines CG(k±2). In other words, it can be said that the charge pump circuit 53 has a higher current supply capability per signal line CG than the charge pump circuit 52. Therefore, the selected word line WLk and the adjacent word lines WL(k±1) have a higher rate of voltage rise and a steeper slope than those of the non-adjacent word lines WL(k±2). Accordingly, at time t41 earlier than time t43 at which the near ends (Near) of the non-adjacent word lines WL(k±2) reach the voltage VREAD, the near end (Near) of each of the selected word line WLk and the adjacent word lines WL(k±1) reaches the voltage VOPTK, and thereafter, holds the voltage VOPTK. The voltage at the far end (Far) of each of the selected word line WLk and the adjacent word lines WL(k±1) rises with a delay from that at the near end (Near).

At time t42, when the voltage at the near ends (Near) of the non-adjacent word lines WL(k±2) rises to the level corresponding to the voltage VOPTK, the voltage VREADK is applied to the selected signal line CGk and the adjacent signal lines CG(k±1).

For example, the voltages at the near ends (Near) of the selected word line WLk and the adjacent word lines WL(k±1) gradually rise, and reach the voltage VREADK. The voltages at the far ends (Far) of the selected word line WLk and the adjacent word lines WL(k±1) rise with a delay from those at the near ends (Near). That is, the process of rising the voltages of the selected word line WLk and the adjacent word lines WL(k±1) to the voltage VREADK includes a first part for rising the voltages to the voltage VOPTK, a second part for holding the voltage VOPTK, and a third part for rising the voltage to the voltage VREADK.

The operation from time t43 to time t47 is the same as the operation from time t32 to time t36 of the second embodiment.

### 3.3 Effects

The semiconductor memory device 3 according to the third embodiment can shorten the processing time required for a read operation of reading data from a memory cell, as in the second embodiment.

Also, in the semiconductor memory device 3 according to the third embodiment, at the time of the read operation, the selected word line WLk and the adjacent word lines WL(k±1) are once raised to the voltage VOPTK. After that, the voltage of the non-adjacent word lines WL(k±2) reaches the voltage VOPTK, and then the selected word line WLk and the adjacent word lines WL(k±1) are raised to the voltage VREADK. As a result, the potential difference between the selected word line WLk and the adjacent word lines WL(k±1) becomes smaller. Thus, it is possible to suppress the occurrence of GIDL in the vicinity of the selected word line WLk, and suppress hot carrier injection. Further, the potential difference to be caused at the time of a voltage rise can be made smaller between the adjacent word lines WL(k±1) and the non-adjacent word lines (the adjacent word line WL(k+1) and the non-adjacent word line WL(k+2), for example) adjacent to the adjacent word lines WL(k±1) in the Z direction. Specifically, the voltage VOPTK is adjusted to have a potential difference from the word lines WL(k±2) rising to the voltage VREAD so that hot carrier injection due to GIDL is less likely to occur. Thus, hot carrier injection in the vicinity of the adjacent word lines WL(k±1) can be suppressed. In the above manner, a decrease in the reliability of the semiconductor memory device 3 can be prevented.

### 4. Fourth Embodiment

Next, a semiconductor memory device according to a fourth embodiment is described. In a read operation, a semiconductor memory device 3 according to the fourth embodiment performs an operation different from that by the semiconductor memory device 3 according to the third embodiment. In the description below, explanation of configurations and operations similar to those of the third embodiment will not be repeated, and operations different from those of the third embodiment will be mainly explained.

### 4.1 Read Operation

An example read operation in the semiconductor memory device 3 according to the fourth embodiment is now described, with a read operation of reading lower page data being a typical example among page-by-page read operations.

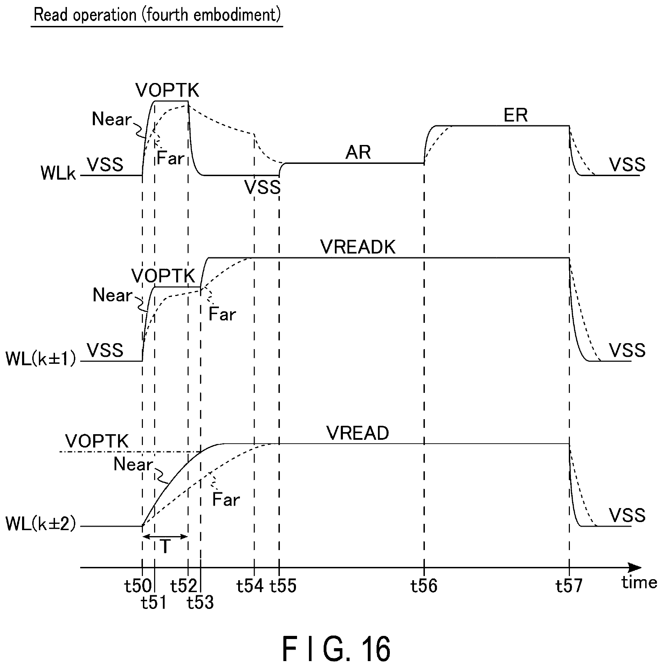

FIG. 16 is a timing chart showing an example read operation of reading lower page data in the semiconductor memory device according to the fourth embodiment. Note that, as for the voltage of each word line WL, the voltage at the near end (Near) is indicated by a solid line, and the voltage at the far end (Far) is indicated by a dashed line.

As illustrated in FIG. 16, at the start of the read operation, the voltage of each of the selected word line WLk, the adjacent word lines WL(k±1), and the non-adjacent word lines WL(k±2) is the voltage VSS, for example.

From t50 to t51, an operation in which the voltage VREAD is applied to non-adjacent signal lines CG(k±2), and the voltage VOPTK is applied to a selected signal line CGk and adjacent signal lines CG(k±1) is the same as the operation from t40 to t41 of the third embodiment.

After a predetermined period T has elapsed since time t50, the voltage VSS is applied to the selected signal line CGk at time t52. The period T is a period that is longer than the period from the time when the application of the voltage VOPTK to the selected signal line CGk is started (t50) till the time when the voltage at the near end (Near) of the selected word line WLk reaches the voltage VOPTK (t51), and is shorter than the period till a voltage VREADK is applied to the adjacent signal lines CG(k±1) (t53) described later. The period T is measured inside the sequencer 14 using self-timer control or the like.

For example, the voltage at the near end (Near) of the selected word line WLk falls sharply, and reaches the voltage VSS. The voltage at the far end (Far) of the selected word line WLk is affected by the coupling current caused by the capacitance interference between the selected word line WLk and the adjacent word lines WL(k±1), and falls slowly with a delay from that at the near end (Near).

After the voltage at the near ends (Near) of the non-adjacent word lines WL(k±2) has risen to the level corresponding to the voltage VOPTK, the voltage VREADK is applied to the adjacent signal lines CG(k±1) at time t53.

For example, the voltage at the near ends (Near) of the adjacent word lines WL(k±1) is affected by the coupling current caused by the capacitance interference between the selected word line WLk and the adjacent word lines WL(k±1), and rises slowly, to reach the voltage VREADK. The voltage at the far ends (Far) of the adjacent word lines WL(k±1) rises with a delay from that at the near ends (Near), and reaches the voltage VREADK at time t54. That is, the process of rising the voltage of the selected word line WLk to the voltage VREADK includes a first part for rising the voltage to the voltage VOPTK, a second part for holding the voltage VOPTK, and a third part for rising the voltage to the voltage VREADK.

The operation from time t55 to time t57 is the same as the operation from time t45 to time t47 of the third embodiment.

### 4.2 Effects

The semiconductor memory device 3 according to the fourth embodiment can shorten the processing time required for a read operation of reading data from a memory cell, as in the third embodiment.

Further, in the semiconductor memory device 3 according to the fourth embodiment, at the time of the read operation, the voltage of the selected word line WLk is raised to the voltage VOPTK at a maximum. The voltage VOPTK is a voltage of a magnitude that is great enough to remove residual electrons in the channels in memory pillars MP, and has the same effect as an effect to raise the selected word line WLk to the voltage VREAD or the voltage VREADK. Further, when the voltage VSS is applied to the selected word line WLk to lower the voltage, the voltage fall width (VOPTK - VSS) can be made smaller. Thus, the time required for a voltage fall can also be shortened accordingly. As a result, the time at which the voltage at the far end (Far) of the selected word line WLk reaches a read voltage (the read voltage AR, for example) is advanced. Accordingly, reading can be started at an earlier time, and thus, the time required for the entire read operation can be shortened.

Also, in the semiconductor memory device 3 according to the fourth embodiment, the period T is measured with self-timer control, and the timing to apply the voltage VSS to the selected word line WLk is determined. Therefore, it is not necessary to use a dedicated power supply to manage the voltage. Thus, an increase in the circuit area can be prevented.

### 5. Fifth Embodiment

Next, a semiconductor memory device according to a fifth embodiment is described. In a read operation, a semiconductor memory device 3 according to the fifth embodiment performs an operation different from that by the semiconductor memory device 3 according to the third embodiment. In the description below, explanation of configurations and operations similar to those of the third embodiment will not be repeated, and operations different from those of the third embodiment will be mainly explained.

### 5.1 Circuit Configuration of a Driver Module

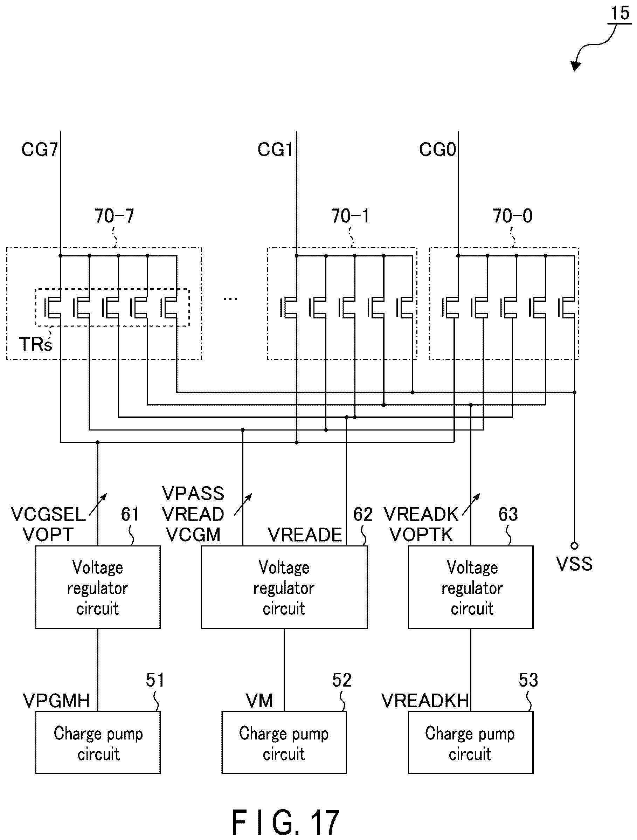

FIG. 17 is a circuit diagram showing an example circuit configuration of a driver module included in the semiconductor memory device according to the fifth embodiment.

As illustrated in FIG. 17, in the driver module 15 included in the semiconductor memory device 3 according to the fifth embodiment, the voltage regulator circuit 61 further generates a voltage VOPT. The voltage VOPT is a voltage that is higher than the highest threshold distribution (the maximum threshold at the "G" level), and is lower than the voltage VOPTK. It is desirable that the voltage VOPT be as low as possible while satisfying a condition. The voltage regulator circuit 61 outputs the voltage VOPT from the same output end as the voltage VCGSEL, for example.

### 5.2 Read Operation

An example read operation in the semiconductor memory device 3 according to the fifth embodiment is now described, with a read operation of reading lower page data being a typical example among page-by-page read operations.

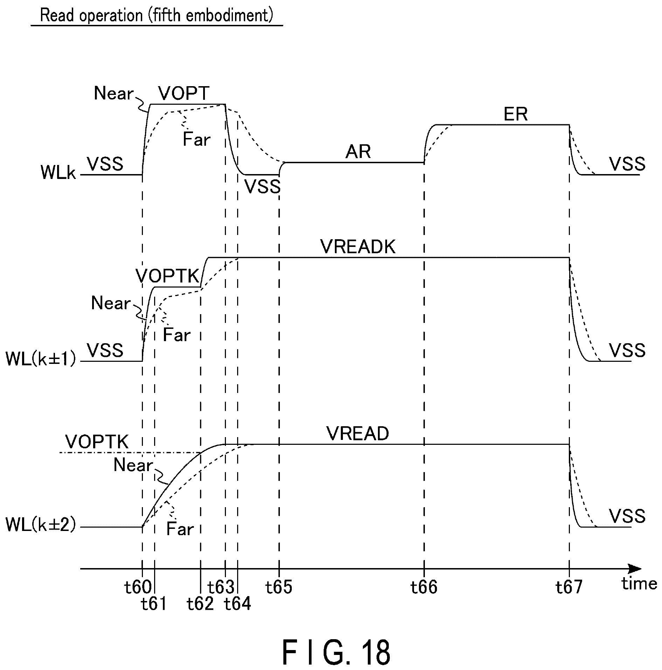

FIG. 18 is a timing chart showing an example read operation of reading lower page data in the semiconductor memory device according to the fifth embodiment. Note that, as for the voltage of each word line WL, the voltage at the near end (Near) is indicated by a solid line, and the voltage at the far end (Far) is indicated by a dashed line.

As illustrated in FIG. 18, at the start of the read operation, the voltage of each of the selected word line WLk, the adjacent word lines WL(k±1), and the non-adjacent word lines WL(k±2) is a voltage VSS, for example.

At time t60, the voltage VREAD is applied to the non-adjacent signal lines CG(k±2).

For example, the voltage at the near ends (Near) of the non-adjacent word lines WL(k±2) gradually rises, and reaches the voltage VREAD at time t63. The voltage at the far ends (Far) of the non-adjacent word lines WL(k±2) rises with a delay from that at the near ends (Near).

At time t60, the voltage VOPT is applied to the selected signal line CGk. Further, the voltage VOPTK is applied to the adjacent signal lines CG(k±1).

The voltage regulator circuit 61 that generates the voltage VOPT to be applied to the selected signal line CGk is coupled to the charge pump circuit 61. The voltage regulator circuit 63 that generates the voltage VOPTK to be applied to the adjacent signal lines CG(k±1) is coupled to the charge pump circuit 53. On the other hand, the voltage regulator circuit 62 that generates the voltage VREAD to be applied to the non-adjacent signal lines CG(k±2) is coupled to the charge pump circuit 52. While the charge pump circuit 52 supplies current to a large number of signal lines, the charge pump circuits 51 and 53 supply currents only to the one signal line of the selected signal line CGk and the two signal lines of the adjacent signal lines CG(k±1), respectively. Accordingly, the current to be supplied to each of the selected signal line CGk and the adjacent signal lines CG(k±1) can be larger than the current to be supplied to each of the non-adjacent signal lines CG(k±2). That is, it can be said that the charge pump circuits 51 and 53 have a higher current supply capability per signal line CG than the charge pump circuit 52. Therefore, the adjacent word lines WL(k±1) have a higher rate of voltage rise and a steeper slope than those of the non-adjacent word lines WL(k±2). Accordingly, at time t61 earlier than time t63 at which the near ends (Near) of the non-adjacent word lines WL(k±2) reach the voltage VREAD, the near ends (Near) of the adjacent word lines WL(k±1) reach the voltage VOPTK, and thereafter, holds the voltage VOPTK. The voltage at the far ends (Far) of the adjacent word lines WL(k±1) rises with a delay from that at the near ends (Near). Further, the rate of rise in the voltage of the selected word line WLk is substantially equal to that of the adjacent word lines WL(k±1). Since the voltage VOPT is lower than the voltage VOPTK, and the voltage rise width is smaller (VOPT - VSS < VOPTK - VSS), the near end (Near) of the selected word line WLk reaches the voltage VOPT at a time earlier than time t61 at which the near ends (Near) of the adjacent word lines WL(k±1) reach the voltage VREADK. The voltage at the far end (Far) of the selected word line WLk rises with a delay from that at the near end (Near).

After the voltage at the near ends (Near) of the non-adjacent word lines WL(k±2) has risen to the level corresponding to the voltage VOPTK, the voltage VREADK is applied to the adjacent signal lines CG(k±1) at time t62.

For example, the voltage at the near ends (Near) of the adjacent word lines WL(k±1) is affected by the coupling current caused by the capacitance interference between the selected word line WLk and the adjacent word lines WL(k±1), and rises slowly, to reach the voltage VREADK. The voltage at the far ends (Far) of the adjacent word lines WL(k±1) rises with a delay from that at the near ends (Near), and reaches the voltage VREADK at time t64. That is, the process of rising the voltage of the selected word line WLk to the voltage VREADK includes a first part for rising the voltage to the voltage VOPTK, a second part for holding the voltage VOPTK, and a third part for rising the voltage to the voltage VREADK.

After the voltage at the near end (Near) of the selected word line WLk has reached the voltage VREAD, the voltage to be applied to the selected signal line CGk is lowered to the voltage VSS at time t63. Note that the voltage to be applied to the selected signal line CGk may be lowered to the voltage VSS before the voltages at the far ends (Far) of the selected word line WLk and the non-adjacent word lines WL(k±2) reach the voltage VREAD.

For example, the voltage at the near end (Near) of the selected word line WLk falls sharply to the voltage VSS. In the period from time t63 to time t64, the voltage at the far end (Far) of the selected word line WLk is affected by the coupling current caused by the capacitance interference between the selected word line WLk and the adjacent word lines WL(k±1), and falls slowly with a delay from that at the near end (Near). After time t64, the voltage at the far end (Far) of the selected word line WLk falls to the neighborhood of the read voltage AR at a higher rate than that in the period from time t63 to time t64.

The operation from time t65 to time t67 is the same as the operation from time t55 to time t57 of the fourth embodiment.

### 5.3 Effects

The semiconductor memory device 3 according to the fifth embodiment can shorten the processing time required for a read operation of reading data from a memory cell, as in the third embodiment.

Further, in the semiconductor memory device 3 according to the fifth embodiment, at the time of the read operation, the voltage of the selected word line WLk is raised to the voltage VOPT at a maximum. The voltage VOPT is a voltage of a magnitude that is great enough to remove residual electrons in the channels in memory pillars MP, and has the same effect as an effect to raise the selected word line WLk to the voltage VREAD or the voltage VREADK. Also, in a case where the voltage VSS is applied to the selected word line WLk to lower the voltage, the voltage fall width (VOPT - VSS) can be made smaller. Thus, the time required for a voltage fall can also be shortened accordingly. As a result, the time at which the voltage at the far end (Far) of the selected word line WLk reaches a read voltage (the read voltage AR, for example) is advanced. Accordingly, reading can be started at an earlier time, and thus, the time required for the entire read operation can be shortened.

Also, in the semiconductor memory device 3 according to the fifth embodiment, the voltage VOPT is controlled by the voltage regulator circuit 61. Thus, the variance of voltage values is small, and voltage control is easy. Accordingly, the margin for coping with the variance of voltage values can be narrowed, and the lowest possible voltage VOPT that satisfies the condition can be generated. Thus, the voltage fall width can be made smaller, and the time required for the entire read operation can be shortened.

### 6. Sixth Embodiment

Next, a semiconductor memory device according to a sixth embodiment is described. In a write operation, a semiconductor memory device 3 according to the sixth embodiment performs an operation different from that by the semiconductor memory device 3 according to the first embodiment. In the description below, explanation of configurations and operations similar to those of the first embodiment will not be repeated, and operations different from those of the first embodiment will be mainly explained.

### 6.1 Circuit Configuration of a Driver Module

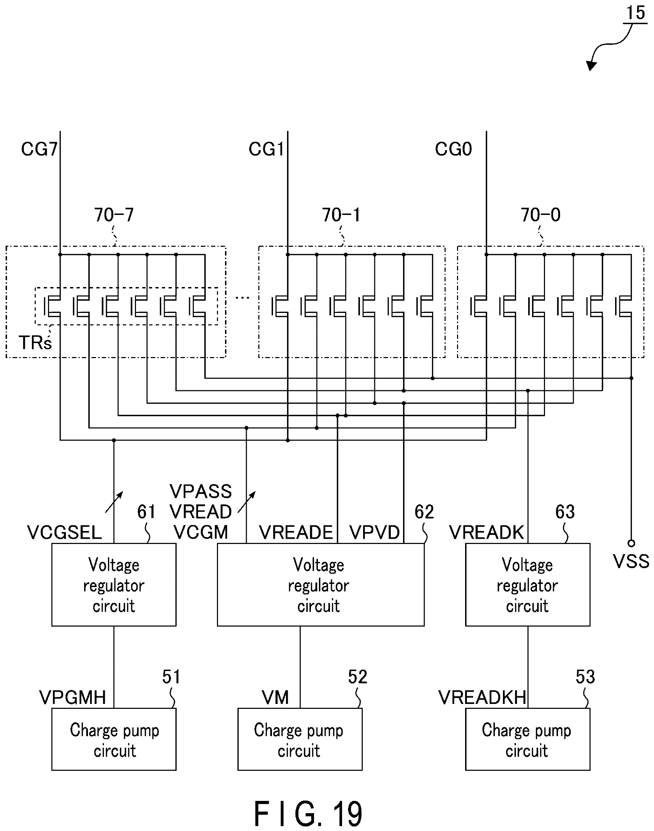

FIG. 19 is a circuit diagram showing an example circuit configuration of a driver module included in the semiconductor memory device according to the sixth embodiment.

As illustrated in FIG. 19, in the driver module 15 included in the semiconductor memory device 3 according to the sixth embodiment, the voltage regulator circuit 62 further generates a voltage VPVD. The voltage VPVD is a voltage that is higher than the lowest threshold distribution (the maximum threshold voltage at the "Er" level) and the voltage VCGM, and is lower than the voltage VREADE. Each memory cell transistor MT in an erased state (in which no data has been written) enters an ON-state when the voltage VPVD is applied to the gate thereof. For example, the voltage regulator circuit 62 outputs the voltage VPVD from an output end different from the output end from which voltages VPASS, VREAD, and VCGM are output, and the output end from which the voltage VREADE is output.

### 6.2 Write Operation

An example write operation in the semiconductor memory device 3 according to the sixth embodiment is now described, with a typical example being a program loop in which the "A" level and the "B" level are set as verify targets in a verify operation.

In the description below, the word lines WL coupled to memory cell transistors MT(k+2), MT(k+3), ..., and MT7 in which data has already been written will be referred to specifically as the written non-adjacent word lines WL(k+i) (i being an integer of 2 or greater). The word lines WL coupled to memory cell transistors MT(k-2), MT(k-3), ..., and MT0 in which data has not yet been written will be referred to specifically as the unwritten non-adjacent word lines WL(k-i).

In the following description, WL(k+2) will be explained as a typical example of a written non-adjacent word line WL(k+i). WL(k-2) will be explained as a typical example of an unwritten non-adjacent word line WL(k-i). Note that, as for a word line WL0 and a word line WL1, it is assumed that there are word lines WL (not shown) corresponding to the unwritten adjacent word line WL(k-1) and the unwritten non-adjacent word line WL(k-2). Note that, as for a word line WL6 and a word line WL7, it is assumed that there are word lines WL (not shown) corresponding to the written adjacent word line WL(k+1) and the written non-adjacent word line WL(k+2).

The signal line CG(k+2) coupled to the written non-adjacent word line WL(k+2) will be referred to as the written non-adjacent signal line CG(k+2). The signal line CG(k-2) coupled to the unwritten non-adjacent word line WL(k-2) will be referred to as the unwritten non-adjacent signal line CG(k-2).

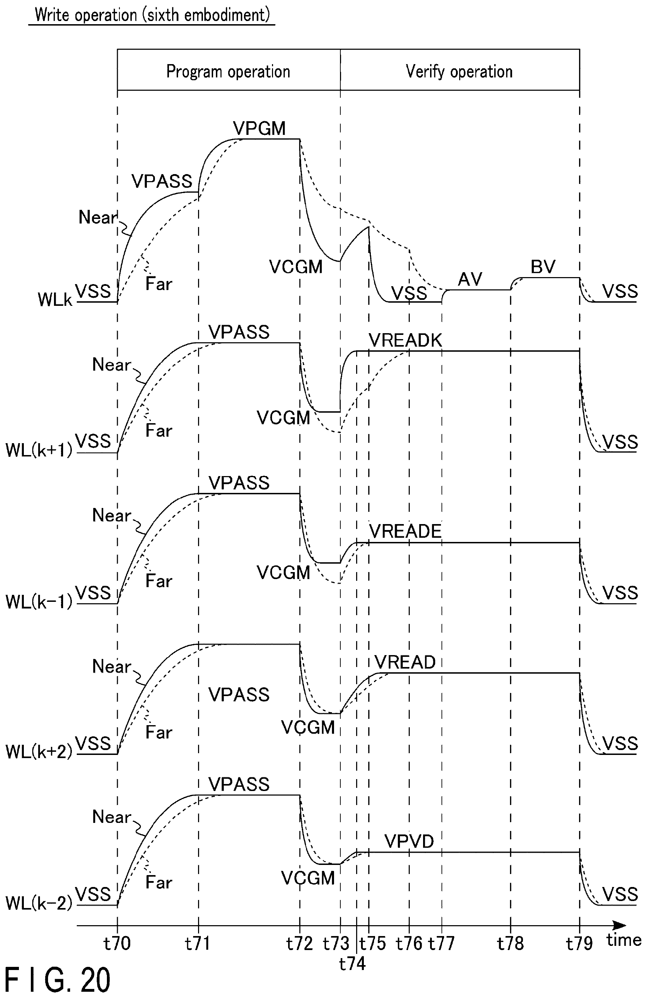

FIG. 20 is a timing chart showing an example write operation in the semiconductor memory device according to the sixth embodiment. FIG. 20 shows a write operation in a program loop in which the "A" level and the "B" level are set as verify targets in the verify operation. Note that, as for the voltage of each word line WL, the voltage at the near end (Near) is indicated by a solid line, and the voltage at the far end (Far) is indicated by a dashed line.

As illustrated in FIG. 20, at the start of the program loop, the voltage of each of the selected word line WLk, the written adjacent word line WL(k+1), the unwritten adjacent word line WL(k-1), the written non-adjacent signal line CG(k+2), and the unwritten non-adjacent signal line CG(k-2) is the voltage VSS, for example.

At time t70, the voltage VPASS is applied to the selected signal line CGk, the written adjacent signal line CG(k+1), the unwritten adjacent signal line CG(k-1), the written non-adjacent signal line CG(k+2), and the unwritten non-adjacent signal line CG(k-2).

For example, the voltage at the near end (Near) of each of the selected word line WLk, the written adjacent word line WL(k+1), the unwritten adjacent word line WL(k-1), the written non-adjacent word line WL(k+2), and the unwritten non-adjacent word line WL(k-2) gradually rises, and reaches the voltage VPASS. The voltage at the far end (Far) of each of the selected word line WLk, the written adjacent word line WL(k+1), the unwritten adjacent word line WL(k-1), the written non-adjacent word line WL(k+2), and the unwritten non-adjacent word line WL(k-2) rises with a delay from that at the near end (Near).

Next, at time t71, the voltage VPGM is applied to the selected signal line CGk. This operation is the same as the operation at time t21 of the first embodiment.

Next, at time t72, the voltage VCGM is applied to the selected signal line CGk, the written adjacent signal line CG(k+1), the unwritten adjacent signal line CG(k-1), the written non-adjacent word line WL(k+2), and the unwritten non-adjacent word line WL(k-2).

For example, the voltage at the near end (Near) of the selected word line WLk falls sharply, and reaches a voltage in the neighborhood of the voltage VCGM at time t73. The voltage at the far end (Far) of the selected word line WLk has a delay from that at the near end (Near) immediately after the voltage application, and falls while being affected by the coupling current caused by the capacitance interference between the selected word line WLk and the adjacent word lines WL(k±1).

The voltage at the near end (Near) of each of the written adjacent word line WL(k+1) and the unwritten adjacent word line WL(k-1) falls sharply, and reaches the voltage VCGM before time t73. The voltage at the far end (Far) of each of the written adjacent word line WL(k+1) and the unwritten adjacent word line WL(k-1) is affected by the coupling current caused by the capacitance interference between the written adjacent word line WL(k+1) and the selected word line WLk, falls sharply, and can have a lower voltage than the voltage VCGM.

The voltage at the near end (Near) of each of the written non-adjacent word line WL(k+2) and the unwritten non-adjacent word line WL(k-2) falls sharply, and reaches the voltage VCGM before time t73. The voltage at the far end (Far) of each of the written non-adjacent word line WL(k+2) and the unwritten non-adjacent word line WL(k-2) falls with a delay from that at the near end (Near).

Next, at time t73, the voltage VREAD is applied to the selected signal line CGk and the written non-adjacent signal line CG(k+2). The voltage VREADK is applied to the written adjacent signal line CG(k+1). The voltage VREADE is applied to the unwritten adjacent signal line CG(k-1). The voltage VPVD is applied to the unwritten non-adjacent signal line CG(k-2).

The voltage regulator circuit 63 that generates the voltage VREADK to be applied to the written adjacent signal line CG(k+1) is coupled to the charge pump circuit 53. On the other hand, the voltage regulator circuit 62 that generates the voltage VREAD to be applied to the selected signal line CGk and the written non-adjacent signal line CG(k+2), the voltage VREADE to be applied to the unwritten adjacent signal line CG(k-1), and the voltage VPVD to be applied to the unwritten non-adjacent signal line CG(k-2) is coupled to the charge pump circuit 52. While the charge pump circuit 52 supplies current to a large number of signal lines, the charge pump circuit 53 supplies current only to the one signal line of the written adjacent signal line CG(k+1). Accordingly, the current to be supplied to the written adjacent signal line CG(k+1) can be larger than the current to be supplied to each of the selected signal line CGk, the unwritten adjacent signal line CG(k-1), the written non-adjacent signal line CG(k+2), and the unwritten non-adjacent signal line CG(k-2). That is, it can be said that the charge pump circuit 53 has a higher current supply capability per signal line CG than the charge pump circuit 52. Because of this, the written adjacent word line WL(k+1) has a higher rate of voltage rise and a steeper slope than those of the selected word line WLk, the unwritten adjacent word line WL(k-1), the written non-adjacent word line WL(k+2), and the unwritten non-adjacent word line WL(k-2). Accordingly, the voltage at the near end (Near) of the written adjacent word line WL(k+1) reaches the voltage VREADK at time t74, for example. The voltage at the far end (Far) of the written adjacent word line WL(k+1) has a delay from that at the near end (Near), and rises slowly, being affected by the coupling current caused by the capacitance interference between the written adjacent word line WL(k+1) and the selected word line WLk.

After time t73, the voltages at the near ends (Near) of the selected word line WLk, the unwritten adjacent word line WL(k-1), the written non-adjacent word line WL(k+2), and the unwritten non-adjacent word line WL(k-2) rise at substantially the same rate (slope). Accordingly, the unwritten non-adjacent word line WL(k-2) having the lower voltage applied thereto reaches the voltage VPVD first. The unwritten adjacent word line WL(k-1) reaches the voltage VREADE next. The voltages at the far ends (Far) of the selected word line WLk, the unwritten adjacent word line WL(k-1), the written non-adjacent word line WL(k+2), and the unwritten non-adjacent word line WL(k-2) rise with a delay from those at the near ends (Near). For example, the far end (Far) of the unwritten adjacent word line WL(k-1) reaches the voltage VREADE around time t75.

After that, at time t75, the voltage VSS is applied to the selected signal line CGk.

After time t75, being affected by the coupling current caused by the capacitance interference between the written adjacent word line WL(k+1) and the selected word line WLk, the voltage at the far end (Far) of the written adjacent word line WL(k+1) rises at a slower rate, and reaches the voltage VREADK at time t76.

The voltage at the near end (Near) of the selected word line WLk falls sharply, and reaches the voltage VSS. In the period from time t75 to time t76, the voltage at the far end (Far) of the selected word line WLk falls slowly, being affected by the coupling current caused by the capacitance interference between the selected word line WLk and the written adjacent word line WL(k+1). After time t76, the influence of the coupling current becomes smaller, and accordingly, the voltage falls at a higher rate, and converges to the verify voltage AV around time t77.

The verify operation using the verify voltages AV and BV in the period from time t77 to time t79 is the same as the operation from time t27 to time t29 in the first embodiment.

Lastly, at time t79, the voltage VSS is applied to the selected signal line CGk, the written adjacent word line WL(k+1), the unwritten adjacent word line WL(k-1), the written non-adjacent word line WL(k+2), and the unwritten non-adjacent word line WL(k-2). As a result, the voltages of the selected word line WLk, the written adjacent word line WL(k+1), the unwritten adjacent word line WL(k-1), the written non-adjacent word line WL(k+2), and the unwritten non-adjacent word line WL(k-2) fall to the voltage VSS, and return to the state at the time of the start of the program loop.

### 6.3 Effects

The semiconductor memory device 3 according to the sixth embodiment can shorten the processing time required for a write operation of writing data into a memory cell, as in the first embodiment.

Further, in the semiconductor memory device 3 according to the sixth embodiment, at the time of the verify operation, the voltage of the unwritten non-adjacent word line WL(k-2) is raised to the voltage VPVD at a maximum. As a result, the current for charging the unwritten non-adjacent word line WL(k-2) can be reduced, and the current can be diverted to charging of the other word lines WL. Thus, the semiconductor memory device 3 can be operated efficiently.

Note that no data has been written into the memory cell transistor MT(k-2) (in an erased state) having the unwritten non-adjacent word line WL(k-2) coupled to the gate thereof. Therefore, even if the voltage VPVD is applied instead of the voltage VREAD in the verify operation, the memory cell transistor MT(k-2) is in an ON-state. Accordingly, the verify operation is not inhibited. Since the unwritten non-adjacent word line WL(k-2) is not adjacent to the selected word line WLk in the Z direction, the voltage of the unwritten non-adjacent word line WL(k-2) does not interfere with the gate of the selected memory cell transistor MTk, and the selected memory cell transistor MTk is not turned off.

Further, in a case where the current flowing in the NAND string NS is different between the time of verification and the time of reading, when the data written by the write operation is read, there is a possibility that the data memorized in the memory cell transistor MT cannot be correctly read. In the semiconductor memory device 3 according to the sixth embodiment, no data is memorized in the memory cell transistor MT(k-2) at the time of verification of the selected memory cell transistor MTk, and the threshold voltage is at the "Er" level. As the voltage VPVD lower than the voltage VREAD is applied to the memory cell transistor MT(k-2), the resistance value in the channel of the memory cell transistor MT(k-2) increases, compared with that in the case where the voltage VREAD is applied. As a result, it is possible to simulate the resistance value in the channel when the voltage VREAD is applied to the memory cell transistor MT(k-2) at any level at the time of reading, for example. Thus, the current flowing in the NAND string can be equalized at the time of verification and at the time of reading, and a decrease in the reliability of the semiconductor memory device 3 can be prevented.

### 7. Seventh Embodiment

Next, a semiconductor memory device according to a seventh embodiment is described. In a write operation, a semiconductor memory device 3 according to the seventh embodiment performs an operation different from that by the semiconductor memory device 3 according to the sixth embodiment. In the description below, explanation of configurations and operations similar to those of the sixth embodiment will not be repeated, and operations different from those of the sixth embodiment will be mainly explained.

### 7.1 Write Operation

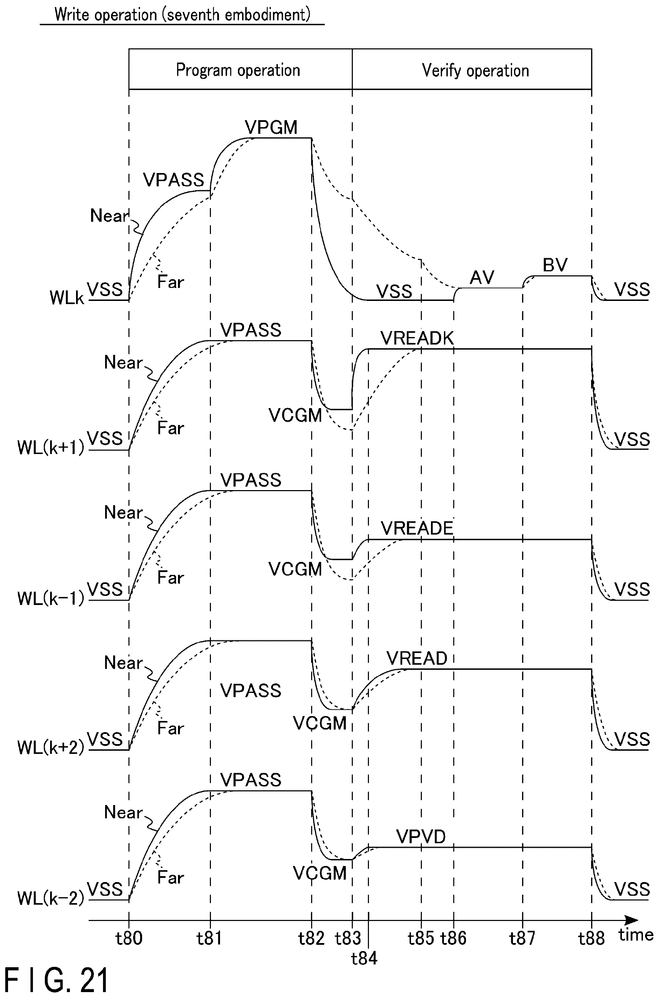

FIG. 21 is a timing chart showing an example write operation in the semiconductor memory device according to the seventh embodiment. FIG. 21 shows a write operation in a program loop in which the "A" level and the "B" level are set as verify targets in a verify operation. Note that, as for the voltage of each word line WL, the voltage at the near end (Near) is indicated by a solid line, and the voltage at the far end (Far) is indicated by a dashed line.

As illustrated in FIG. 21, at the start of the program loop, the voltage of each of the selected word line WLk, the written adjacent word line WL(k+1), the unwritten adjacent word line WL(k-1), the written non-adjacent signal line CG(k+2), and the unwritten non-adjacent signal line CG(k-2) is a voltage VSS, for example.

The operation in the period from time t80 to time t82 is the same as the operation in the period from time t70 to time t72 of the sixth embodiment.

At time t82, the voltage VSS is applied to the selected signal line CGk.

For example, the voltage at the near end (Near) of the selected word line WLk falls sharply. The voltage at the far end (Far) of the selected word line WLk falls with a delay from that at the near end (Near) immediately after the voltage application.

On the other hand, at time t82, the voltage VCGM is applied to the written adjacent signal line CG(k+1), the unwritten adjacent signal line CG(k-1), the written non-adjacent word line WL(k+2), and the unwritten non-adjacent word line WL(k-2).

The voltage at the near end (Near) of each of the written adjacent word line WL(k+1) and the unwritten adjacent word line WL(k-1) falls sharply, and reaches the voltage VCGM before time t83. The voltage at the far end (Far) of each of the written adjacent word line WL(k+1) and the unwritten adjacent word line WL(k-1) is affected by the coupling current caused by the capacitance interference between the written adjacent word line WL(k+1) and the selected word line WLk, falls sharply, and can have a lower voltage than the voltage VCGM.

The voltage at the near end (Near) of each of the written non-adjacent word line WL(k+2) and the unwritten non-adjacent word line WL(k-2) falls sharply, and reaches the voltage VCGM before time t83. The voltage at the far end (Far) of each of the written non-adjacent word line WL(k+2) and the unwritten non-adjacent word line WL(k-2) falls with a delay from that at the near end (Near).

Next, at time t83, the voltage VREADK is applied to the written adjacent signal line CG(k+1). The voltage VREADE is applied to the unwritten adjacent signal line CG(k-1). The voltage VREAD is applied to the written non-adjacent signal line CG(k+2). The voltage VPVD is applied to the unwritten non-adjacent signal line CG(k-2).

For example, the voltage at the near end (Near) of the written adjacent word line WL(k+1) reaches the voltage VREADK at time t84. The voltage at the far end (Far) of the written adjacent word line WL(k+1) has a delay from that at the near end (Near), rises slowly while being affected by the coupling current with the selected word line WLk, and reaches the voltage VREADK at time t85.

After time t83, the voltages at the near ends (Near) of the selected word line WLk, the unwritten adjacent word line WL(k-1), the written non-adjacent word line WL(k+2), and the unwritten non-adjacent word line WL(k-2) rise at substantially the same rate (slope). Accordingly, the unwritten non-adjacent word line WL(k-2) having the lower voltage applied thereto reaches the voltage VPVD first. The unwritten adjacent word line WL(k-1) reaches the voltage VREADE next. The voltages at the far ends (Far) of the selected word line WLk, the unwritten adjacent word line WL(k-1), the written non-adjacent word line WL(k+2), and the unwritten non-adjacent word line WL(k-2) rise with a delay from those at the near ends (Near). In particular, the far end (Far) of the unwritten adjacent word line WL(k-1) is affected by the coupling current with the selected word line WLk, and gradually rises, to reach the voltage VREADE.

After time t83, the voltage at the far end (Far) of the selected word line WLk falls slowly, being affected by the coupling current with the written adjacent word line WL(k+1) and the unwritten adjacent word line WL(k-1). After time t85, the influence of the coupling current becomes smaller, and accordingly, the voltage falls at a higher rate, and converges to the verify voltage AV around time t86.

The verify operation using the verify voltages AV and BV and the operation between program loops after time t86 are the same as the operations after time t77 in the sixth embodiment.

### 7.2 Effects

The semiconductor memory device 3 according to the seventh embodiment can shorten the processing time required for a write operation of writing data into a memory cell, streamline operations, and prevent a decrease in the reliability of the semiconductor memory device 3, as in the sixth embodiment.

Further, in the semiconductor memory device 3 according to the seventh embodiment, at a time of shifting from the program operation to the verify operation, the voltage to be applied to the selected signal line CGk shifts from the voltage VPGM to the voltage VSS, without passing through any other voltage. As a result, the voltage rise at the near end (Near) of the selected word line WLk does not occur. Thus, the voltage fall width can be made smaller, and the rate of fall in the voltage at the far end (Far) of the selected word line WLk is increased, as in the period from time t73 to time t74 in the sixth embodiment. Accordingly, the time at which the voltage at the far end (Far) of the selected word line WLk reaches a verify voltage (the verify voltage AV, for example) is advanced. Thus, the verify operation can be started at an earlier time, and the time required for the entire write operation can be shortened.

Note that, to perform the write operation according to the seventh embodiment, the voltage VPGM needs to be sufficiently high. In a case where the voltage VPGM is sufficiently high, the voltage at the far end (Far) of the selected word line WLk has a voltage value that is great enough to remove residual electrons in the channel of the selected memory cell transistor MTk at time t83 when the verify operation is started. Thus, the voltage of the selected word line WLk does not need to be raised again, and the voltage VSS can be applied directly thereto.

### 8. Eighth Embodiment

Next, a semiconductor memory device according to an eighth embodiment is described. In a write operation, a semiconductor memory device 3 according to the eighth embodiment performs an operation different from that by the semiconductor memory device 3 according to the sixth embodiment. In the description below, explanation of configurations and operations similar to those of the sixth embodiment will not be repeated, and operations different from those of the sixth embodiment will be mainly explained.

### 8.1 Write Operation

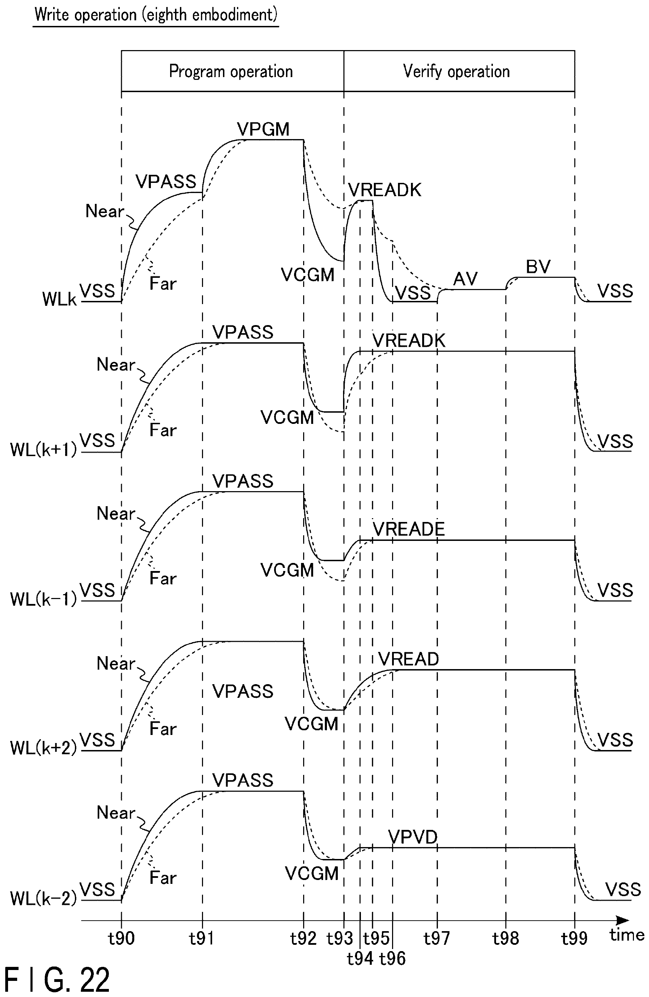

FIG. 22 is a timing chart showing an example write operation in the semiconductor memory device according to the eighth embodiment. FIG. 22 shows a write operation in a program loop in which the "A" level and the "B" level are set as verify targets in a verify operation. Note that, as for the voltage of each word line WL, the voltage at the near end (Near) is indicated by a solid line, and the voltage at the far end (Far) is indicated by a dashed line.

As illustrated in FIG. 22, at the start of the program loop, the voltage of each of the selected word line WLk, the written adjacent word line WL(k+1), the unwritten adjacent word line WL(k-1), the written non-adjacent signal line CG(k+2), and the unwritten non-adjacent signal line CG(k-2) is the voltage VSS, for example.

The program operation in the period from time t90 to time t93 is the same as the operation in the period from time t70 to time t73 of the sixth embodiment.

At time t93, the voltage VREADK is applied to the selected signal line CGk and the written adjacent signal line CG(k+1). The voltage VREADE is applied to the unwritten adjacent signal line CG(k-1). The voltage VREAD is applied to the written non-adjacent signal line CG(k+2). The voltage VPVD is applied to the unwritten non-adjacent signal line CG(k-2).

The voltage regulator circuit 63 that generates the voltage VREADK to be applied to the selected signal line CGk and the written adjacent signal line CG(k+1) is coupled to the charge pump circuit 53. On the other hand, the voltage regulator circuit 62 that generates the voltage VREADE to be applied to the unwritten adjacent signal line CG(k-1), the voltage VREAD to be applied to the written non-adjacent signal line CG(k+2), and the voltage VPVD to be applied to the unwritten non-adjacent signal line CG(k-2) is coupled to the charge pump circuit 52. While the charge pump circuit 52 supplies current to a large number of signal lines, the charge pump circuit 53 supplies current only to the two signal lines of the selected signal line CGk and the written adjacent signal line CG(k+1). Accordingly, the current to be supplied to the written adjacent signal line CG(k+1) can be larger than the current to be supplied to each of the selected signal line CGk, the unwritten adjacent signal line CG(k-1), the written non-adjacent signal line CG(k+2), and the unwritten non-adjacent signal line CG(k-2). That is, it can be said that the charge pump circuit 53 has a higher current supply capability per signal line CG than the charge pump circuit 52. Because of this, the selected word line WLk and the written adjacent word line WL(k+1) have a higher rate of voltage rise and a steeper slope than those of the unwritten adjacent word line WL(k-1), the written non-adjacent word line WL(k+2), and the unwritten non-adjacent word line WL(k-2). Accordingly, the voltage at the near end (Near) of each of the selected word line WLk and the written adjacent word line WL(k+1) reaches the voltage VREADK at time t94, for example. The voltage at the far end (Far) of the selected word line WLk converges in the neighborhood of the voltage VREADK. The voltage at the far end (Far) of the written adjacent word line WL(k+1) has a delay from that at the near end (Near), and rises slowly, being affected by the coupling current caused by the capacitance interference between the written adjacent word line WL(k+1) and the selected word line WLk.

After that, at time t95, the voltage VSS is applied to the selected word line WLk.

After time t95, being affected by the coupling current caused by the capacitance interference between the written adjacent word line WL(k+1) and the selected word line WLk, the voltage at the far end (Far) of the written adjacent word line WL(k+1) rises at a slower rate, and reaches the voltage VREADK at time t96.

For example, the voltage at the near end (Near) of the selected word line WLk falls sharply, and reaches the voltage VSS. In the period from time t95 to time t96, the voltage at the far end (Far) of the selected word line WLk falls slowly, being affected by the coupling current caused by the capacitance interference between the selected word line WLk and the written adjacent word line WL(k+1). After time t96, the influence of the coupling current becomes smaller, and accordingly, the voltage falls at a higher rate, and converges to the verify voltage AV around time t97.

After time t93, the voltages at the near ends (Near) of the unwritten adjacent word line WL(k-1), the written non-adjacent word line WL(k+2), and the unwritten non-adjacent word line WL(k-2) rise at substantially the same rate (slope). Accordingly, the unwritten non-adjacent word line WL(k-2) having the lower voltage applied thereto reaches the voltage VPVD first. After that, the unwritten adjacent word line WL(k-1) reaches the voltage VREADE. The voltages at the far ends (Far) of the unwritten adjacent word line WL(k-1), the written non-adjacent word line WL(k+2), and the unwritten non-adjacent word line WL(k-2) rise with a delay from those at the near ends (Near).

The verify operation using the verify voltages AV and BV and the operation between program loops after time t97 are the same as the operations after time t77 in the sixth embodiment.

### 8.2 Effects

The semiconductor memory device 3 according to the eighth embodiment can shorten the processing time required for a write operation of writing data into a memory cell, streamline operations, and prevent a decrease in the reliability of the semiconductor memory device 3, as in the

### sixth embodiment.

Further, in the semiconductor memory device 3 according to the eighth embodiment, at the time of the verify operation, the selected word line WLk, together with the written adjacent word line WL(k+1), is raised to the voltage VREADK at the same rate of rise. Thus, it is possible to suppress inter-word-line capacitance interference that might occur between the selected word line WLk and the written adjacent word line WL(k+1) at the time of a voltage rise. As a result, the time required for a voltage rise can be shortened, and the processing time required for the entire write operation can be shortened. Also, it is possible to suppress the occurrence of GIDL in the vicinity of the selected word line WLk, and suppress hot carrier injection. Accordingly, a decrease in the reliability of the semiconductor memory device 3 can be prevented.

### 9. Ninth Embodiment

Next, a semiconductor memory device according to a ninth embodiment is described. In a write operation, a semiconductor memory device 3 according to the ninth embodiment performs an operation different from that by the semiconductor memory device 3 according to the eighth embodiment. In the description below, explanation of configurations and operations similar to those of the eighth embodiment will not be repeated, and operations different from those of the eighth embodiment will be mainly explained.

### 9.1 Write Operation

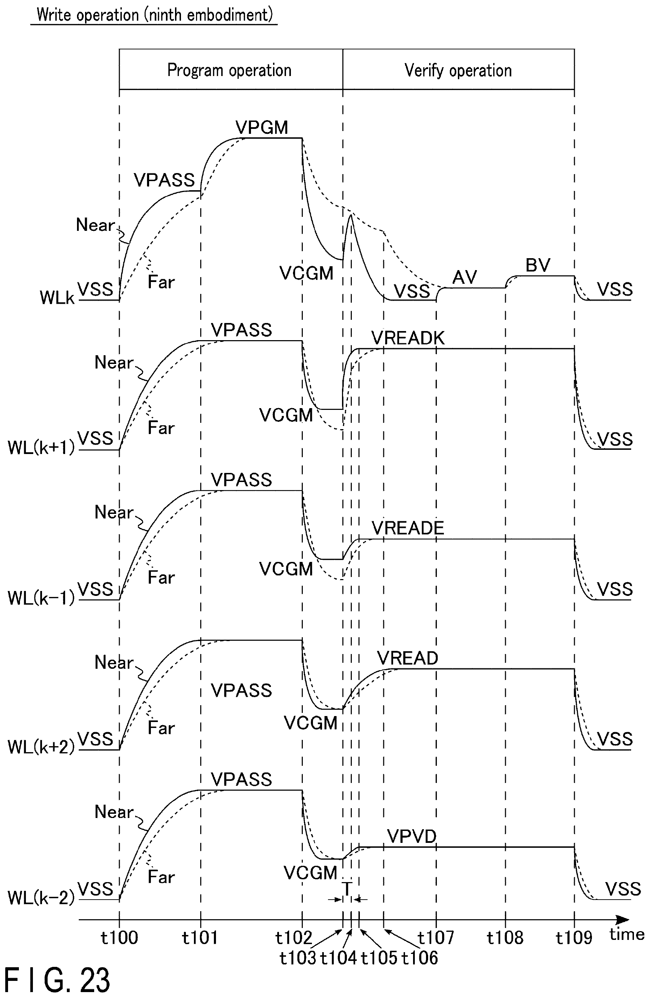

FIG. 23 is a timing chart showing an example write operation in the semiconductor memory device according to the ninth embodiment. FIG. 23 shows a write operation in a program loop in which the "A" level and the "B" level are set as verify targets in a verify operation. Note that, as for the voltage of each word line WL, the voltage at the near end (Near) is indicated by a solid line, and the voltage at the far end (Far) is indicated by a dashed line.

As illustrated in FIG. 23, at the start of the program loop, the voltage of each of the selected word line WLk, the written adjacent word line WL(k+1), the unwritten adjacent word line WL(k-1), the written non-adjacent signal line CG(k+2), and the unwritten non-adjacent signal line CG(k-2) is the voltage VSS, for example.

The program operation in the period from time t100 to time t103 is the same as the operation in the period from time t90 to time t93 of the eighth embodiment.

At time t103, the voltage VREADK is applied to the selected signal line CGk and the written adjacent signal line CG(k+1). The voltage VREADE is applied to the unwritten adjacent signal line CG(k-1). The voltage VREAD is applied to the written non-adjacent signal line CG(k+2). The voltage VPVD is applied to the unwritten non-adjacent signal line CG(k-2).

The voltage regulator circuit 63 that generates the voltage VREADK to be applied to the selected signal line CGk and the written adjacent signal line CG(k+1) is coupled to the charge pump circuit 53. On the other hand, the voltage regulator circuit 62 that generates the voltage VREADE to be applied to the unwritten adjacent signal line CG(k-1), the voltage VREAD to be applied to the written non-adjacent signal line CG(k+2), and the voltage VPVD to be applied to the unwritten non-adjacent signal line CG(k-2) is coupled to the charge pump circuit 52. While the charge pump circuit 52 supplies current to a large number of signal lines, the charge pump circuit 53 supplies current only to the two signal lines of the selected signal line CGk and the written adjacent signal line CG(k+1). Accordingly, the current to be supplied to each of the selected signal line CGk and the written adjacent signal line CG(k+1) can be larger than the current to be supplied to each of the unwritten adjacent signal line CG(k-1), the written non-adjacent signal line CG(k+2), and the unwritten non-adjacent signal line CG(k-2). That is, it can be said that the charge pump circuit 53 has a higher current supply capability per signal line CG than the charge pump circuit 52. Because of this, the selected word line WLk and the written adjacent word line WL(k+1) have a higher rate of voltage rise and a steeper slope than those of the unwritten adjacent word line WL(k-1), the written non-adjacent word line WL(k+2), and the unwritten non-adjacent word line WL(k-2). Accordingly, the voltage at the near end (Near) of the written adjacent word line WL(k+1) reaches the voltage VREADK at time t105, for example. The voltage at the far end (Far) of the written adjacent word line WL(k+1) has a delay from that at the near end (Near), and rises slowly, being affected by the coupling current caused by the capacitance interference between the written adjacent word line WL(k+1) and the selected word line WLk.

After a predetermined period T has elapsed since time t103, the voltage VSS is applied to the selected word line WLk at time t104. The period T is a period that is shorter than the period from the time when the application of the voltage VREADK to the selected signal line CGk is started (t103) till the time when the voltage at the near end (Near) of the written adjacent word line WL(k+1) reaches the voltage VREADK (t105). In the period T, residual electrons in the channel are removed. The period T is measured inside the sequencer 14 using self-timer control or the like.

After time t104, being affected by the coupling current caused by the capacitance interference between the written adjacent word line WL(k+1) and the selected word line WLk, the voltage at the far end (Far) of the written adjacent word line WL(k+1) rises at a slower rate, and reaches the voltage VREADK at time t106.

For example, the voltage at the near end (Near) of the selected word line WLk falls sharply, and reaches the voltage VSS. In the period from time t104 to time t106, the voltage at the far end (Far) of the selected word line WLk falls slowly, being affected by the coupling current caused by the capacitance interference between the selected word line WLk, and the written adjacent word line WL(k+1) and the unwritten adjacent word line WL(k-1). After time t106, the influence of the coupling current becomes smaller, and accordingly, the voltage falls at a higher rate, and converges to the verify voltage AV around time t107.

After time t103, the voltages at the near ends (Near) of the unwritten adjacent word line WL(k-1), the written non-adjacent signal line CG(k+2), and the unwritten non-adjacent signal line CG(k-2) rise at substantially the same rate (slope). Accordingly, the unwritten non-adjacent word line WL(k-2) having the lower voltage applied thereto reaches the voltage VPVD first. After that, the unwritten adjacent word line WL(k-1) reaches the voltage VREADE. The voltages at the far ends (Far) of the unwritten adjacent word line WL(k-1), the written non-adjacent signal line CG(k+2), and the unwritten non-adjacent signal line CG(k-2) rise with a delay from those at the near ends (Near). In particular, being affected by the coupling current caused by the capacitance interference between the unwritten adjacent word line WL(k-1) and the selected word line WLk, the voltage at the far end (Far) of the unwritten adjacent word line WL(k-1) rises at a slower rate, and reaches the voltage VREADE before time t106.

The verify operation using the verify voltages AV and BV and the operation between program loops after time t107 are the same as the operations after time t97 in the eighth embodiment.

### 9.2 Effects

The semiconductor memory device 3 according to the ninth embodiment can shorten the processing time required for a write operation of writing data into a memory cell, streamline operations, and prevent a decrease in the reliability of the semiconductor memory device 3, as in the eighth embodiment.

Further, in the semiconductor memory device 3 according to the ninth embodiment, at the time of the verify operation, the voltage VSS is applied while the voltage of the selected word line WLk is being raised. Therefore, the voltage at the near end (Near) of the selected word line WLk starts falling before reaching the voltage VREADK. Accordingly, in a case where the voltage VSS is applied to the selected word line WLk to lower the voltage, the voltage fall width can be made smaller. Thus, the time required for a voltage fall can also be shortened accordingly. As a result, the time at which the voltage at the far end (Far) of the selected word line WLk reaches a verify voltage (the verify voltage AV, for example) is advanced. Thus, verification can be started at an earlier time, and the time required for the entire write operation can be shortened.

Also, in the semiconductor memory device 3 according to the ninth embodiment, the period T is measured with self-timer control, and the timing to apply the voltage VSS to the selected word line WLk is determined. Therefore, it is not necessary to use a dedicated power supply to manage the voltage. Thus, an increase in the circuit area can be prevented.

### 10. Tenth Embodiment

Next, a semiconductor memory device according to a tenth embodiment is described. In a write operation, a semiconductor memory device 3 according to the tenth embodiment performs an operation different from that by the semiconductor memory device 3 according to the eighth embodiment. In the description below, explanation of configurations and operations similar to those of the eighth embodiment will not be repeated, and operations different from those of the eighth embodiment will be mainly explained.

### 10.1 Circuit Configuration of a Driver Module

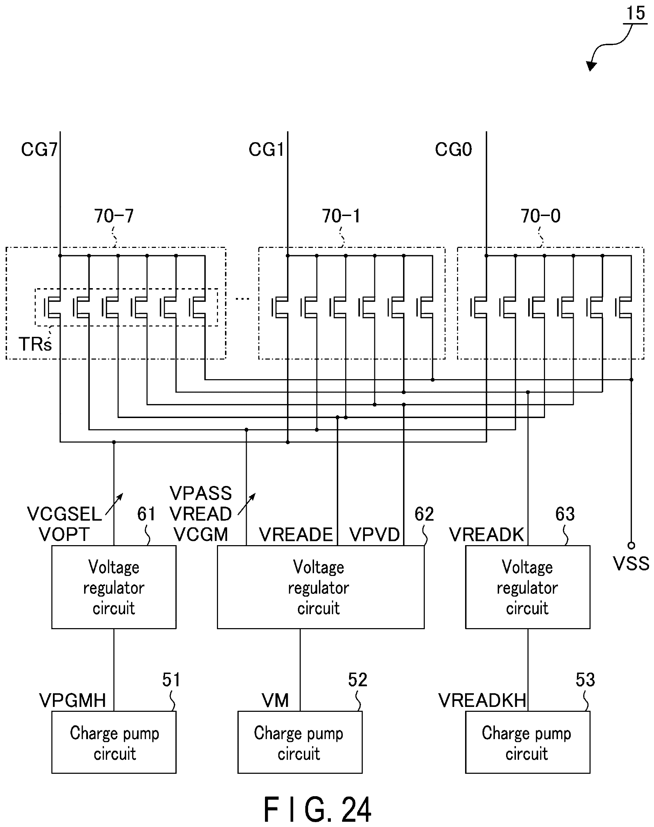

FIG. 24 is a circuit diagram showing an example circuit configuration of a driver module included in the semiconductor memory device according to the tenth embodiment.

As illustrated in FIG. 24, in the driver module 15 included in the semiconductor memory device 3 according to the tenth embodiment, the voltage regulator circuit 61 further generates a voltage VOPT. The voltage VOPT is a voltage that is higher than the highest threshold distribution (the maximum threshold at the "G" level), and is lower than the voltage VREAD. It is desirable that the voltage VOPT be as low as possible while satisfying a condition. The voltage regulator circuit 61 outputs the voltage VOPT from the same output end as a voltage VCGSEL, for example.

### 10.2 Write Operation

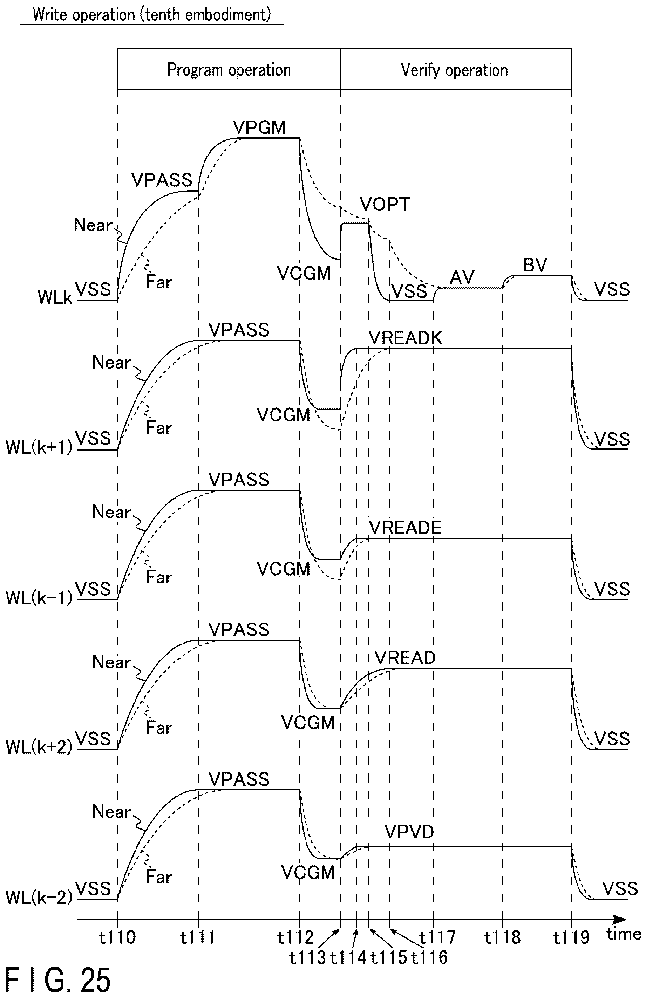

FIG. 25 is a timing chart showing an example write operation in the semiconductor memory device according to the tenth embodiment. FIG. 25 shows a write operation in a program loop in which the "A" level and the "B" level are set as verify targets in the verify operation. Note that, as for the voltage of each word line WL, the voltage at the near end (Near) is indicated by a solid line, and the voltage at the far end (Far) is indicated by a dashed line.

As illustrated in FIG. 25, at the start of the program loop, the voltage of each of the selected word line WLk, the written adjacent word line WL(k+1), the unwritten adjacent word line WL(k-1), the written non-adjacent signal line CG(k+2), and the unwritten non-adjacent signal line CG(k-2) is the voltage VSS, for example.

The program operation in the period from time t110 to time t113 is the same as the operation in the period from time t90 to time t93 of the eighth embodiment.

At time t113, the voltage VOPT is applied to a selected signal line CGk. The voltage VREADK is applied to the written adjacent signal line CG(k+1). The voltage VREADE is applied to the unwritten adjacent signal line CG(k-1). The voltage VREAD is applied to the written non-adjacent signal line CG(k+2). The voltage VPVD is applied to the unwritten non-adjacent signal line CG(k-2).

The voltage regulator circuit 61 that generates the voltage VOPT to be applied to the selected signal line CGk is coupled to the charge pump circuit 51. The voltage regulator circuit 63 that generates the voltage VREADK to be applied to the written adjacent signal line CG(k+1) is coupled to the charge pump circuit 53. On the other hand, the voltage regulator circuit 62 that generates the voltage VREADE to be applied to the unwritten adjacent signal line CG(k-1), the voltage VREAD to be applied to the written non-adjacent signal line CG(k+2), and the voltage VPVD to be applied to the unwritten non-adjacent signal line CG(k-2) is coupled to the charge pump circuit 52. While the charge pump circuit 52 supplies current to a large number of signal lines, the charge pump circuit 51 and 53 supplies current only to the signal lines of the selected signal line CGk and the written adjacent signal line CG(k+1), respectively. Accordingly, the current to be supplied to each of the selected signal line CGk and the written adjacent signal line CG(k+1) can be larger than the current to be supplied to each of the unwritten adjacent signal line CG(k-1), the written non-adjacent signal line CG(k+2), and the unwritten non-adjacent signal line CG(k-2). That is, it can be said that the charge pump circuit 51 and 53 has a higher current supply capability per signal line CG than the charge pump circuit 52. Because of this, the selected word line WLk and the written adjacent word line WL(k+1) have a higher rate of voltage rise and a steeper slope than those of the unwritten adjacent word line WL(k-1), the written non-adjacent word line WL(k+2), and the unwritten non-adjacent word line WL(k-2). Accordingly, the voltage at the near end (Near) of the selected word line WLk reaches the voltage VOPT before time t114, for example. The voltage at the near end (Near) of the written adjacent word line WL(k+1) reaches the voltage VREADK at time t114. The voltage at the far end (Far) of the selected word line WLk converges in the neighborhood of the voltage VOPT. The voltage at the far end (Far) of the written adjacent word line WL(k+1) has a delay from that at the near end (Near), and rises slowly, being affected by the coupling current caused by the capacitance interference between the written adjacent word line WL(k+1) and the selected word line WLk.

After that, at time t115, the voltage VSS is applied to the selected word line WLk.

After time t115, being affected by the coupling current caused by the capacitance interference between the written adjacent word line WL(k+1) and the selected word line WLk, the voltage at the far end (Far) of the written adjacent word line WL(k+1) rises at a slower rate, and reaches the voltage VREADK at time t116.

For example, the voltage at the near end (Near) of the selected word line WLk falls sharply, and reaches the voltage VSS. In the period from time t115 to time t116, the voltage at the far end (Far) of the selected word line WLk falls slowly, being affected by the coupling current caused by the capacitance interference between the selected word line WLk and the written adjacent word line WL(k+1). After time t116, the influence of the coupling current becomes smaller, and accordingly, the voltage falls at a higher rate, and converges to the verify voltage AV around time t117.

After time t113, the voltages of the unwritten adjacent word line WL(k-1), the written non-adjacent signal line CG(k+2), and the unwritten non-adjacent signal line CG(k-2) rise at substantially the same rate (slope). Accordingly, the unwritten non-adjacent word line WL(k-2) having the lower voltage applied thereto reaches the voltage VPVD first. After that, the unwritten adjacent word line WL(k-1) reaches the voltage VREADE. The voltages at the far ends (Far) of the unwritten adjacent word line WL(k-1), the written non-adjacent signal line CG(k+2), and the unwritten non-adjacent signal line CG(k-2) rise with a delay from those at the near ends (Near).

The verify operation using the verify voltages AV and BV and the operation between program loops after time t117 are the same as the operations after time t97 in the eighth embodiment.

### 10.3 Effects

The semiconductor memory device 3 according to the tenth embodiment can shorten the processing time required for a write operation of writing data into a memory cell, streamline operations, and prevent a decrease in the reliability of the semiconductor memory device 3, as in the eighth embodiment.

Further, in the semiconductor memory device 3 according to the tenth embodiment, at the time of the verify operation, the voltage of the selected word line WLk is raised to the voltage VOPT at a maximum. The voltage VOPT is a voltage of a magnitude that is great enough to remove residual electrons in the channels in memory pillars MP, and has the same effect as an effect to raise the selected word line WLk to the voltage VREAD or the voltage VREADK. Also, in a case where the voltage VSS is applied to the selected word line WLk to lower the voltage, the voltage fall width (VOPT - VSS) can be made smaller. Thus, the time required for a voltage fall can also be shortened accordingly. As a result, the time at which the voltage at the far end (Far) of the selected word line WLk reaches a verify voltage (the verify voltage AV, for example) is advanced. Thus, verification can be started at an earlier time, and the time required for the entire write operation can be shortened.

Also, in the semiconductor memory device 3 according to the tenth embodiment, the voltage VOPT is controlled by the voltage regulator circuit 61. Thus, the variance of voltage values is small, and voltage control is easy. Accordingly, the margin for coping with the variance of voltage values can be narrowed, and the lowest possible voltage VOPT that satisfies the condition can be generated. Thus, the voltage fall width can be made smaller, and the time required for the entire write operation can be shortened.

### 11. Other Aspects

In the embodiments described above, cases where the memory cell transistors MT are sequentially selected as write targets starting from the side of the bit line BL in a write operation have been described. However, the memory cell transistors MT may be sequentially selected as write targets starting from the side of the source line SL. In this case, the word line WL(k-1) is a written adjacent word line, and the word line WL(k+1) is an unwritten adjacent word line. Likewise, a word line WL(k-i) is a written non-adjacent word line, and a word line WL(k+i) is an unwritten non-adjacent word line (i being an integer of 2 or greater).

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or further embodiments as would fall within the scope and spirit of the inventions.

Clause 1. A semiconductor memory device (3) comprising:
a first interconnect layer (WLk), a second interconnect layer (WL(k+1)), and a plurality of third interconnect layers (WL(k+2)) that are sequentially arranged while being apart from one another in a first direction (Z);
a memory pillar (MP) that extends in the first direction (Z) and includes a portion intersecting the first interconnect layer (WLk) and functioning as a first memory cell (MTk); and
a control circuit (14) that controls a read operation of reading data memorized in the first memory cell (MCk), wherein,
during the read operation, the control circuit (14) performs
a first operation of changing a voltage of the plurality of third interconnect layers (WL(k+2)) from a first voltage (VSS or VCGM) to a second voltage (VREAD) higher than the first voltage (VSS or VCGM) at a first rate;
a second operation of changing a voltage of the second interconnect layer (WL(k+1)) from the first voltage (VSS or VCGM) to a third voltage (VREADK) higher than the second voltage (VREAD) at a second rate higher than the first rate; and,
a third operation of changing a voltage of the first interconnect layer (WLk) to a fourth voltage (VCGSEL) which is a read level voltage of the first memory cell (MCk).

Clause 2. The semiconductor memory device (3) according to claim 1, further comprising
a fourth interconnect layer (WL(k-1)) and a plurality of fifth interconnect layers (WL(k-2)) that are provided on a side opposite to the second interconnect layer (WL(k+1)) with respect to the first interconnect layer (WLk), and are sequentially arranged while being apart from each other in the first direction (Z), wherein
the first operation further includes changing a voltage of the plurality of fifth interconnect layers (WL(k-2)) from the first voltage (VSS or VCGM) to the second voltage (VREAD) at the first rate, and
the second operation further includes changing a voltage of the fourth interconnect layer (WL(k-1)) from the first voltage (VSS or VCGM) to the third voltage (VREADK) at the second rate.

Clause 3. The semiconductor memory device (3) according to claim 1, further comprising
a fourth interconnect layer (WL(k-1)) and a plurality of fifth interconnect layers (WL(k-2)) that are sequentially arranged on a side opposite to the second interconnect layer (WL(k+1)) with respect to the first interconnect layer (WLk), while being apart from each other in the first direction (Z), wherein,
the memory pillar (MP) further includes portions intersecting with the second interconnect layer (WL(k+1)), the plurality of third interconnect layers (WL(k+2)), the fourth interconnect layer (WL(k-1)), and the plurality of fifth interconnect layers (WL(k-2)), and functioning as a second memory cell (MT(k+1)), a plurality of third memory cells (MT(k+2)), a fourth memory cell (MT(k-1)), and a plurality of fifth memory cells (MT(k-2)), respectively, and,
when data memorized in the first memory cell (MTk) is to be read, each of the second memory cell (MT(k+1)) and the plurality of third memory cells (MT(k+2)) is in a data-memorized state, and each of the fourth memory cell (MT(k-1)) and the plurality of fifth memory cells (MT(k-2)) is in an erased state,
during the read operation, the control circuit (14) further performs a fourth operation of changing a voltage of the fourth interconnect layer (WL(k-1)) from the first voltage (VSS or VCGM) to a fifth voltage (VREADE) lower than the second voltage (VREAD) at the first rate simultaneously with the second operation.

Clause 4. The semiconductor memory device (3) according to claim 3, wherein,
during the read operation, the control circuit (14) further performs a fifth operation of changing a voltage of the plurality of fifth interconnect layer (WL(k-2)) from the first voltage (VSS or VCGM) to a sixth voltage (VPVD) lower than the fifth voltage (VREADE) at the first rate simultaneously with the second operation and the fourth operation.

Clause 5. The semiconductor memory device (3) according to one of claims 1 to 4, wherein,
during the read operation, the control circuit (14) performs
a sixth operation being of changing the voltage of the first interconnect layer (WLk) from the first voltage (VSS or VCGM) to the second voltage (VREAD) at the first rate simultaneously with the first operation, and
the third operation, after the voltages of the first interconnect layer (WLk) and the plurality of third interconnect layers (WL(k+2)) have reached the second voltage (VREAD), and the voltage of the second interconnect layer (WL(k+1)) has reached the third voltage (VREADK).

Clause 6. The semiconductor memory device (3) according to one of claims 1 to 4, wherein,
during the read operation, the control circuit (14) performs
a seventh operation of changing the voltage of the first interconnect layer (WLk) from the first voltage (VSS or VCGM) to the third voltage (VREADK) at the second rate simultaneously with the second operation, and
the third operation, after the voltage of the plurality of third interconnect layers (WL(k+2)) has reached the second voltage (VREAD), and the voltages of the first interconnect layer (WLk) and the second interconnect layer (WL(k+1)) have reached the third voltage (VREADK).

Clause 7. The semiconductor memory device (3) according to claim 6, wherein
the second operation includes and sequentially executes a first part to change the voltage of the second interconnect layer (WL(k+1)) from the first voltage (VSS) to a seventh voltage (VOPTK) lower than the third voltage (VREADK) at the second rate, a second part to hold the voltage of the second interconnect layer (WL(k+1)) at the seventh voltage (VOPTK), and a third part to change the voltage of the second interconnect layer (WL(k+1)) from the seventh voltage (VOPTK) to the third voltage (VREADK) at the second rate,
the seventh operation includes and sequentially executes a fourth part to change the voltage of the first interconnect layer (WLk) from the first voltage (VSS) to the seventh voltage (VOPTK) at the second rate, a fifth part to hold the voltage of the first interconnect layer (WLk) at the seventh voltage (VOPTK), and a sixth part to change the voltage of the first interconnect layer (WLk) from the seventh voltage (VOPTK) to the third voltage (VREADK) at the second rate, and
the third part of the second operation and the sixth part of the seventh operation are executed, after the voltage of the plurality of third interconnect layers (WL(k+2)) has reached the seventh voltage (VOPTK) in the first operation.

Clause 8. The semiconductor memory device (3) according to claim 1 or 2, wherein
the second operation includes and sequentially executes a first part to change the voltage of the second interconnect layer (WL(k+1)) from the first voltage (VSS) to a seventh voltage (VOPTK) lower than the third voltage (VREADK) at the second rate, a second part to hold the voltage of the second interconnect layer (WL(k+1)) at the seventh voltage (VOPTK), and a third part to change the voltage of the second interconnect layer (WL(k+1)) from the seventh voltage (VOPTK) to the third voltage (VREADK) at the second rate,
the third part of the second operation is performed, after the voltage of the plurality of third interconnect layers (WL(k+2)) has reached the seventh voltage (VOPTK) in the first operation,
during the read operation, the control circuit (14) further performs
an eighth operation of changing the voltage of the first interconnect layer (WLk) from the first voltage (VSS) to the seventh voltage (VOPTK) at the second rate simultaneously with the second operation, and
the third operation, after a predetermined time has elapsed since execution of the eighth operation.

Clause 9. The semiconductor memory device (3) according to claim 1 or 2, wherein
the second operation includes and sequentially executes a first part to change the voltage of the second interconnect layer (WL(k+1)) from the first voltage (VSS) to a seventh voltage (VOPTK) lower than the third voltage (VREADK) at the second rate, a second part to hold the voltage of the second interconnect layer (WL(k+1)) at the seventh voltage (VOPTK), and a third part to change the voltage of the second interconnect layer (WL(k+1)) from the seventh voltage (VOPTK) to the third voltage (VREADK) at the second rate,
the third part of the second operation is performed, after the voltage of the plurality of third interconnect layers (WL(k+2)) has reached the seventh voltage (VOPTK) in the first operation,
during the read operation, the control circuit (14) further performs
a ninth operation of changing the voltage of the first interconnect layer (WLk) from the first voltage (VSS) to an eighth voltage (VOPT) lower than the seventh voltage (VOPTK) at the second rate simultaneously with the second operation, and
the third operation, after the voltage of the plurality of third interconnect layers (WL(k+2)) has reached the second voltage (VREAD), the voltage of the second interconnect layer (WL(k+1)) has reached the third voltage (VREADK), and the voltage of the first interconnect layer (WLk) has reached the eighth voltage (VOPT).

Clause 10. The semiconductor memory device (3) according to claim 3 or 4, wherein,
during the read operation, the control circuit (14) further performs
a tenth operation of changing the voltage of the first interconnect layer (WLk) at the second rate simultaneously with the second operation, and
the third operation, after a predetermined time has elapsed since execution of the tenth operation.

Clause 11. The semiconductor memory device according to claim 3 or 4, wherein,
during the read operation, the control circuit (14) further performs
a ninth operation of changing the voltage of the first interconnect layer (WLk) from the first voltage (VCGM) to an eighth voltage (VOPT) lower than the second voltage (VREAD) at the second rate simultaneously with the second operation, and
the third operation, after the voltage of the second interconnect layer (WL(k+1)) has reached the third voltage (VREADK), and the voltage of the first interconnect layer (WLk) has reached the sixth voltage (VOPT).

Clause 12. The semiconductor memory device (3) according to one of claims 1 to 11, wherein
the control circuit (14) simultaneously performs the first operation and the second operation during the read operation.

Clause 13. The semiconductor memory device (3) according to one of claims 1, 3 to 6, 10, or 11 wherein,
during the read operation, the control circuit (14) further performs
an eleventh operation of applying a ninth voltage (VPGM) to the first interconnect layer (WLk) to raise a threshold voltage of the first memory cell (MTk), and
a twelfth operation of changing the voltage of the first interconnect layer (WLk) to the first voltage (VSS or VCGM), after the eleventh operation, and
the control circuit (14) performs the first operation and the second operation, after the twelfth operation.

Clause 14. The semiconductor memory device (3) according to claim 13, wherein,
during the read operation, the control circuit (14) simultaneously performs the first operation, the second operation, and the third operation.

Clause 15. The semiconductor memory device according to claim 1, further comprising:
a first charge pump (62) that supplies a current for changing the voltage of the third interconnect layers (WL(k+2)) from the first voltage (VSS or VCGM) to the second voltage (VREAD) at the first rate; and
a second charge pump (63) that supplies a current for changing the voltage of the second interconnect layer (WL(k+1)) from the first voltage (VSS or VCGM) to the third voltage (VREADK) at the second rate.

## Claims

1. A semiconductor memory device (3) comprising:
a first interconnect layer (WLk), a second interconnect layer (WL(k+1)), and a plurality of third interconnect layers (WL(k+2)) that are sequentially arranged while being apart from one another in a first direction (Z);
a memory pillar (MP) that extends in the first direction (Z) and includes a portion intersecting the first interconnect layer (WLk) and functioning as a first memory cell (MTk); and
a control circuit (14) that controls a read operation of reading data memorized in the first memory cell (MCk), wherein,
during the read operation, the control circuit (14) performs
a first operation of changing a voltage of the plurality of third interconnect layers (WL(k+2)) from a first voltage (VSS or VCGM) to a second voltage (VREAD) higher than the first voltage (VSS or VCGM) at a first rate;
a second operation of changing a voltage of the second interconnect layer (WL(k+1)) from the first voltage (VSS or VCGM) to a third voltage (VREADK) higher than the second voltage (VREAD) at a second rate higher than the first rate; and,
a third operation of changing a voltage of the first interconnect layer (WLk) to a fourth voltage (VCGSEL) which is a read level voltage of the first memory cell (MCk).

2. The semiconductor memory device (3) according to claim 1, further comprising
a fourth interconnect layer (WL(k-1)) and a plurality of fifth interconnect layers (WL(k-2)) that are provided on a side opposite to the second interconnect layer (WL(k+1)) with respect to the first interconnect layer (WLk), and are sequentially arranged while being apart from each other in the first direction (Z), wherein
the first operation further includes changing a voltage of the plurality of fifth interconnect layers (WL(k-2)) from the first voltage (VSS or VCGM) to the second voltage (VREAD) at the first rate, and
the second operation further includes changing a voltage of the fourth interconnect layer (WL(k-1)) from the first voltage (VSS or VCGM) to the third voltage (VREADK) at the second rate.

3. The semiconductor memory device (3) according to claim 1, further comprising
a fourth interconnect layer (WL(k-1)) and a plurality of fifth interconnect layers (WL(k-2)) that are sequentially arranged on a side opposite to the second interconnect layer (WL(k+1)) with respect to the first interconnect layer (WLk), while being apart from each other in the first direction (Z), wherein,
the memory pillar (MP) further includes portions intersecting with the second interconnect layer (WL(k+1)), the plurality of third interconnect layers (WL(k+2)), the fourth interconnect layer (WL(k-1)), and the plurality of fifth interconnect layers (WL(k-2)), and functioning as a second memory cell (MT(k+1)), a plurality of third memory cells (MT(k+2)), a fourth memory cell (MT(k-1)), and a plurality of fifth memory cells (MT(k-2)), respectively, and,
when data memorized in the first memory cell (MTk) is to be read, each of the second memory cell (MT(k+1)) and the plurality of third memory cells (MT(k+2)) is in a data-memorized state, and each of the fourth memory cell (MT(k-1)) and the plurality of fifth memory cells (MT(k-2)) is in an erased state,
during the read operation, the control circuit (14) further performs a fourth operation of changing a voltage of the fourth interconnect layer (WL(k-1)) from the first voltage (VSS or VCGM) to a fifth voltage (VREADE) lower than the second voltage (VREAD) at the first rate simultaneously with the second operation.

4. The semiconductor memory device (3) according to claim 3, wherein,
during the read operation, the control circuit (14) further performs a fifth operation of changing a voltage of the plurality of fifth interconnect layer (WL(k-2)) from the first voltage (VSS or VCGM) to a sixth voltage (VPVD) lower than the fifth voltage (VREADE) at the first rate simultaneously with the second operation and the fourth operation.

5. The semiconductor memory device (3) according to one of claims 1 to 4, wherein,
during the read operation, the control circuit (14) performs
a sixth operation being of changing the voltage of the first interconnect layer (WLk) from the first voltage (VSS or VCGM) to the second voltage (VREAD) at the first rate simultaneously with the first operation, and
the third operation, after the voltages of the first interconnect layer (WLk) and the plurality of third interconnect layers (WL(k+2)) have reached the second voltage (VREAD), and the voltage of the second interconnect layer (WL(k+1)) has reached the third voltage (VREADK).

6. The semiconductor memory device (3) according to one of claims 1 to 4, wherein,
during the read operation, the control circuit (14) performs
a seventh operation of changing the voltage of the first interconnect layer (WLk) from the first voltage (VSS or VCGM) to the third voltage (VREADK) at the second rate simultaneously with the second operation, and
the third operation, after the voltage of the plurality of third interconnect layers (WL(k+2)) has reached the second voltage (VREAD), and the voltages of the first interconnect layer (WLk) and the second interconnect layer (WL(k+1)) have reached the third voltage (VREADK).

7. The semiconductor memory device (3) according to claim 6, wherein
the second operation includes and sequentially executes a first part to change the voltage of the second interconnect layer (WL(k+1)) from the first voltage (VSS) to a seventh voltage (VOPTK) lower than the third voltage (VREADK) at the second rate, a second part to hold the voltage of the second interconnect layer (WL(k+1)) at the seventh voltage (VOPTK), and a third part to change the voltage of the second interconnect layer (WL(k+1)) from the seventh voltage (VOPTK) to the third voltage (VREADK) at the second rate,
the seventh operation includes and sequentially executes a fourth part to change the voltage of the first interconnect layer (WLk) from the first voltage (VSS) to the seventh voltage (VOPTK) at the second rate, a fifth part to hold the voltage of the first interconnect layer (WLk) at the seventh voltage (VOPTK), and a sixth part to change the voltage of the first interconnect layer (WLk) from the seventh voltage (VOPTK) to the third voltage (VREADK) at the second rate, and
the third part of the second operation and the sixth part of the seventh operation are executed, after the voltage of the plurality of third interconnect layers (WL(k+2)) has reached the seventh voltage (VOPTK) in the first operation.

8. The semiconductor memory device (3) according to claim 1 or 2, wherein
the second operation includes and sequentially executes a first part to change the voltage of the second interconnect layer (WL(k+1)) from the first voltage (VSS) to a seventh voltage (VOPTK) lower than the third voltage (VREADK) at the second rate, a second part to hold the voltage of the second interconnect layer (WL(k+1)) at the seventh voltage (VOPTK), and a third part to change the voltage of the second interconnect layer (WL(k+1)) from the seventh voltage (VOPTK) to the third voltage (VREADK) at the second rate,
the third part of the second operation is performed, after the voltage of the plurality of third interconnect layers (WL(k+2)) has reached the seventh voltage (VOPTK) in the first operation,
during the read operation, the control circuit (14) further performs
an eighth operation of changing the voltage of the first interconnect layer (WLk) from the first voltage (VSS) to the seventh voltage (VOPTK) at the second rate simultaneously with the second operation, and
the third operation, after a predetermined time has elapsed since execution of the eighth operation.

9. The semiconductor memory device (3) according to claim 1 or 2, wherein
the second operation includes and sequentially executes a first part to change the voltage of the second interconnect layer (WL(k+1)) from the first voltage (VSS) to a seventh voltage (VOPTK) lower than the third voltage (VREADK) at the second rate, a second part to hold the voltage of the second interconnect layer (WL(k+1)) at the seventh voltage (VOPTK), and a third part to change the voltage of the second interconnect layer (WL(k+1)) from the seventh voltage (VOPTK) to the third voltage (VREADK) at the second rate,
the third part of the second operation is performed, after the voltage of the plurality of third interconnect layers (WL(k+2)) has reached the seventh voltage (VOPTK) in the first operation,
during the read operation, the control circuit (14) further performs
a ninth operation of changing the voltage of the first interconnect layer (WLk) from the first voltage (VSS) to an eighth voltage (VOPT) lower than the seventh voltage (VOPTK) at the second rate simultaneously with the second operation, and
the third operation, after the voltage of the plurality of third interconnect layers (WL(k+2)) has reached the second voltage (VREAD), the voltage of the second interconnect layer (WL(k+1)) has reached the third voltage (VREADK), and the voltage of the first interconnect layer (WLk) has reached the eighth voltage (VOPT).

10. The semiconductor memory device (3) according to claim 3 or 4, wherein,
during the read operation, the control circuit (14) further performs
a tenth operation of changing the voltage of the first interconnect layer (WLk) at the second rate simultaneously with the second operation, and
the third operation, after a predetermined time has elapsed since execution of the tenth operation.

11. The semiconductor memory device according to claim 3 or 4, wherein,
during the read operation, the control circuit (14) further performs
a ninth operation of changing the voltage of the first interconnect layer (WLk) from the first voltage (VCGM) to an eighth voltage (VOPT) lower than the second voltage (VREAD) at the second rate simultaneously with the second operation, and
the third operation, after the voltage of the second interconnect layer (WL(k+1)) has reached the third voltage (VREADK), and the voltage of the first interconnect layer (WLk) has reached the sixth voltage (VOPT).

12. The semiconductor memory device (3) according to one of claims 1 to 11, wherein
the control circuit (14) simultaneously performs the first operation and the second operation during the read operation.

13. The semiconductor memory device (3) according to one of claims 1, 3 to 6, 10, or 11 wherein,
during the read operation, the control circuit (14) further performs
an eleventh operation of applying a ninth voltage (VPGM) to the first interconnect layer (WLk) to raise a threshold voltage of the first memory cell (MTk), and
a twelfth operation of changing the voltage of the first interconnect layer (WLk) to the first voltage (VSS or VCGM), after the eleventh operation, and
the control circuit (14) performs the first operation and the second operation, after the twelfth operation.

14. The semiconductor memory device (3) according to claim 13, wherein,
during the read operation, the control circuit (14) simultaneously performs the first operation, the second operation, and the third operation.

15. The semiconductor memory device according to claim 1, further comprising:
a first charge pump (62) that supplies a current for changing the voltage of the third interconnect layers (WL(k+2)) from the first voltage (VSS or VCGM) to the second voltage (VREAD) at the first rate; and
a second charge pump (63) that supplies a current for changing the voltage of the second interconnect layer (WL(k+1)) from the first voltage (VSS or VCGM) to the third voltage (VREADK) at the second rate.
